# EUROPEAN PATENT APPLICATION

(11) **EP 4 207 250 A1**
(43) Date of publication of application: **05.07.2023**
(21) Application number: 21875371.3
(22) Date of filing: 22.09.2021
(51) Int. Cl.: H01L 21/304

(54) **COMPOSITION FOR CLEANING SEMICONDUCTOR SUBSTRATE, AND CLEANING METHOD**

(30) Priority: 29.09.2020 US 202063084613 P; 03.06.2021 US 202163196417 P
(71) Applicant: MITSUBISHI GAS CHEMICAL COMPANY, INC., Chiyoda-ku Tokyo 100-8324 (JP)
(72) Inventor: HORIE, Hiroaki, Tokyo 125-0051 (JP); HORITA, Akinobu, Tokyo 254-0016 (JP); HAMANAKA, Makoto, Tokyo 125-8601 (JP); SHIMADA, Kenji, Mesa, Arizona 852129716 (US); KIKUNAGA, Takahiro, Mesa, Arizona 852129716 (US)
(74) Representative: Müller-Boré & Partner Patentanwälte PartG mbB
(86) International application number: PCT/JP2021/034850
(87) International publication number: WO 2022/071069

(57) **Abstract**

A cleaning composition for semiconductor substrates comprising hydrogen peroxide (A), a hydrogen peroxide stabilizing agent (B), an alkaline compound (C), and water, wherein the hydrogen peroxide stabilizing agent (B) is at least one selected from the group consisting of oxalic acid, diethylenetriaminepentaacetic acid, hydroxyethyliminodiacetic acid, potassium oxalate, 5-phenyl-1H-tetrazole, triethylenetetraminehexaacetic acid, trans-1,2-cyclohexanediaminetetraacetic acid, 8-quinolinol, L(+)-isoleucine, DL-valine, L(-)-proline, hydroxyethylethylenediaminetriacetic acid, N,N-di(2-hydroxyethyl)glycine, glycine, L-tryptophan, 2,6-pyridinedicarboxylic acid, benzothiazole, and DL-alanine; and the alkaline compound (C) is at least one selected from the group consisting of a quaternary ammonium hydroxide (C1) and potassium hydroxide (C2).

## Description

### [Technical Field]

The present invention relates to a cleaning composition for semiconductor substrates, and a cleaning method.

### [Background Art]

In conventional manufacturing of a semiconductor substrate having highly integrated semiconductor devices, a conductive thin film such as metal film as a conductive wiring material, an interlayer insulating film for insulation between conductive thin films, a hard mask, etc., are formed on a substrate such as a silicon wafer, and then a photoresist is uniformly applied thereon to make a photosensitive layer, which is subjected to selective exposure and development to prepare a desired photoresist pattern. Subsequently, using the photoresist pattern as a mask, the substrate having a laminate including an interlayer insulating film, a hard mask, etc., is dry-etched to form a desired pattern on the substrate. Residues generated in the photoresist patterning and dry-etching (hereinafter referred to as "dry-etching residues") are removed by oxygen plasma ashing, by a cleaning liquid or the like. The sequential steps described above are generally employed.

In recent years, the current density of metal wiring has increased due to progress of design rule miniaturization, so that countermeasures for electromigration, which causes a hole in metal wiring due to movement of atoms constituting the metal wiring when current flows in a metal wiring material, is more strongly required. Examples of the countermeasures include a method of forming a layer of cobalt or a cobalt alloy as a cap metal around a copper wiring, and a method of using cobalt or a cobalt alloy as the metal wiring material. Accordingly, in forming of a semiconductor device on a substrate such as a silicon wafer, methods of removing a hard mask in the presence of copper or a copper alloy, and cobalt or a cobalt alloy, have been proposed.

For example, PTL1 discloses a water-containing cleaning liquid composition comprising specific amounts of hydrogen peroxide, potassium hydroxide, aminopolymethylene phosphonic acid, and a zinc salt each, as a cleaning liquid composition for removing a hard mask of titanium nitride with reduced damage to copper or a copper alloy and cobalt or a cobalt alloy.

Also, PTLs 2 to 18 disclose etching agents, cleaning agents, and peeling agents which contain an oxidant, which is mostly hydrogen peroxide.

### [Citation List]

### [Patent Literature]

PTL 1: JP 2017-076783 A
PTL 2: JP 2020-017732 A
PTL 3: JP 2018-093225 A
PTL 4: JP 2017-031502 A
PTL 5: JP 2018-093225 A
PTL 6: JP 2015-156171 A
PTL 7: JP 2016-176126 A
PTL 8: JP 2015-506583 A
PTL 9: JP 2013-199702 A
PTL 10: JP 2011-228517 A
PTL 11: JP 2009-512194 A
PTL 12: JP 2009-505388 A
PTL 13: JP 2009-041112 A
PTL 14: JP 2009-120870 A
PTL 15: JP 2008-285508 A
PTL 16: JP 2004-317584 A
PTL 17: JP 2004-212818 A
PTL 18: JP 2005-201100 A

### [Summary of Invention]

### [Technical Problem]

Conventional cleaning agents including one in PTL 1, for example, aim at reducing damage to copper or a copper alloy, or cobalt or a cobalt alloy, during cleaning of a semiconductor substrate. In a step of cleaning semiconductor substrates containing a plurality of metals such as copper or a copper alloy and cobalt or a cobalt alloy, however, hydrogen peroxide in a cleaning liquid is easily decomposed, causing problems with cleaning for a long time and repeated use of the cleaning liquid.

Accordingly, a cleaning composition for semiconductor substrates, which has high stability of hydrogen peroxide even in the presence of a plurality of metals such as copper and cobalt and enables to perform cleaning for a long time and repeated use of the cleaning liquid, has been required.

The problem to be solved by the present invention is to provide a cleaning composition for semiconductor substrates, which has high stability of hydrogen peroxide even under coexistence of a plurality of metals including cobalt and enables to perform cleaning for a long time and repeated use of the cleaning liquid.

In particular, a first problem to be solved by the present invention is to provide a cleaning composition for semiconductor substrates, which has high stability of hydrogen peroxide even under coexistence of copper and cobalt and enables to perform cleaning for a long time and repeated use of the cleaning liquid.

Further, a second problem to be solved by the present invention is to provide a cleaning composition for semiconductor substrates, which has high stability of hydrogen peroxide even under coexistence of at least one metal selected from the group consisting of group IV elements, group V elements, group VI elements, group VII elements, group VIII elements, magnesium and aluminum, and of cobalt, and enables to perform cleaning for a long time and repeated use of the cleaning liquid.

### [Solution to Problem]

The present invention provides the following cleaning compositions for semiconductor substrates.
<1> A cleaning composition for semiconductor substrates, comprising hydrogen peroxide (A), a hydrogen peroxide stabilizing agent (B), an alkaline compound (C), and water, wherein the hydrogen peroxide stabilizing agent (B) is at least one selected from the group consisting of oxalic acid, diethylenetriaminepentaacetic acid, hydroxyethyliminodiacetic acid, potassium oxalate, 5-phenyl-1H-tetrazole, triethylenetetraminehexaacetic acid, trans-1,2-cyclohexanediaminetetraacetic acid, 8-quinolinol, L(+)-isoleucine, DL-valine, L(-)-proline, hydroxyethylethylenediaminetriacetic acid, N,N-di(2-hydroxyethyl)glycine, glycine, L-tryptophan, 2,6-pyridinedicarboxylic acid, benzothiazole, and DL-alanine; and the alkaline compound (C) is at least one selected from the group consisting of a quaternary ammonium hydroxide (C1) and potassium hydroxide (C2).
<2> The cleaning composition for semiconductor substrates according to item <1>, wherein the content of the hydrogen peroxide stabilizing agent (B) in the cleaning composition for semiconductor substrates is 0.0001 to 5 mass%.
<3> The cleaning composition for semiconductor substrates according to item <1> or <2>, wherein the content of hydrogen peroxide (A) in the cleaning composition for semiconductor substrates is 10 to 30 mass%.
<4> The cleaning composition for semiconductor substrates according to any one of items <1> to <3>, having a pH of 7 to 12.
<5> The cleaning composition for semiconductor substrates according to any one of items <1> to <4>, further comprising an aminopolymethylene phosphonic acid (D).
<6> The cleaning composition for semiconductor substrates according to item <5>, wherein the content of the aminopolymethylene phosphonic acid (D) in the cleaning composition for semiconductor substrates is 0.00005 to 0.005 mass%.
<7> The cleaning composition for semiconductor substrates according to any one of items <1> to <6>, wherein the content of the quaternary ammonium hydroxide (C1) in the cleaning composition for semiconductor substrates is 0.005 to 10 mass%.
<8> The cleaning composition for semiconductor substrates according to any one of items <1> to <7>, wherein the content of potassium hydroxide (C2) in the cleaning composition for semiconductor substrates is 0.005 to 5 mass%.
<9> The cleaning composition for semiconductor substrates according to any one of items <1> to <8>, wherein the quaternary ammonium hydroxide (C1) is at least one selected from the group consisting of tetramethylammonium hydroxide, tetraethylammonium hydroxide, tetrapropylammonium hydroxide, tetrabutylammonium hydroxide, and benzyltrimethylammonium hydroxide.
<10> The cleaning composition for semiconductor substrates according to any one of items <5> to <9>, wherein the aminopolymethylene phosphonic acid (D) is at least one selected from the group consisting of
   aminotri(methylenephosphonic acid),
   ethylenediaminetetra(methylenephosphonic acid),
   diethylenetriaminepenta(methylenephosphonic acid), and 1,2-propylenediaminetetra(methylenephosphonic acid).
<11> The cleaning composition for semiconductor substrates according to any one of items <1> to <10>, wherein the hydrogen peroxide stabilizing agent (B) is at least one selected from the group consisting of oxalic acid, diethylenetriaminepentaacetic acid, hydroxyethyliminodiacetic acid, potassium oxalate, triethylenetetraminehexaacetic acid, trans-1,2-cyclohexanediaminetetraacetic acid, 8-quinolinol, hydroxyethylethylenediaminetriacetic acid, 5-phenyl-1H-tetrazole, N,N-di(2-hydroxyethyl)glycine, and benzothiazole.
<12> The cleaning composition for semiconductor substrates according to any one of items <1> to <11>, substantially free of ammonia and ammonium ion (NH₄⁺).
<13> The cleaning composition for semiconductor substrates according to any one of items <1> to <12>, for use in cleaning semiconductor substrates having a hard mask containing at least one selected from the group consisting of titanium and titanium nitride.
<14> The cleaning composition for semiconductor substrates according to any one of items <1> to <13>, for use in cleaning semiconductor substrates containing cobalt and copper.
<15> The cleaning composition for semiconductor substrates according to any one of items <1> to <14>, wherein, after addition of 400 ppb by mass of cobalt ions and 1000 ppb by mass of copper ions based on the total amount of the cleaning composition for semiconductor substrates and treatment at 50°C for 6 hours, the residual ratio of hydrogen peroxide (A) is 50% or more based on the content of hydrogen peroxide before the treatment.
<16> The cleaning composition for semiconductor substrates according to any one of items <1> to <13>, for use in cleaning semiconductor substrates containing: at least one metal selected from the group consisting of group IV elements, group V elements, group VI elements, group VII elements, group VIII elements, magnesium and aluminum; and cobalt.
<17> The cleaning composition for semiconductor substrates according to item <16>, wherein the at least one metal selected from the group consisting of group IV elements, group V elements, group VI elements, group VII elements, group VIII elements, magnesium and aluminum is at least one metal selected from the group consisting of titanium, zirconium, hafnium, tantalum, tungsten, manganese, ruthenium, magnesium and aluminum.
<18> A cleaning method for cleaning a semiconductor substrate by using the cleaning composition for semiconductor substrates according to any one of items <1> to <15> under coexistence of cobalt ions and copper ions.
<19> A cleaning method for cleaning a semiconductor substrate containing cobalt and copper by using the cleaning composition for semiconductor substrates according to any one of items <1> to <15>.
<20> A cleaning method for cleaning a semiconductor substrate by using the cleaning composition for semiconductor substrates according to any one of items <1> to <13> and items <16> and <17> under coexistence of ions of at least one metal selected from the group consisting of group IV elements, group V elements, group VI elements, group VII elements, group VIII elements, magnesium and aluminum, and of cobalt ions.
<21> A cleaning method for cleaning a semiconductor substrate containing: at least one metal selected from the group consisting of group IV elements, group V elements, group VI elements, group VII elements, group VIII elements, magnesium and aluminum; and cobalt, by using the cleaning composition for semiconductor substrates according to any one of items <1> to <13> and items <16> and <17>.
<22> The cleaning method according to any one of items <18> to <21>, for cleaning a semiconductor substrate having a hard mask containing at least one selected from the group consisting of titanium and titanium nitride.
<23> A cleaning method for removing at least one selected from the group consisting of dry etching residues and a hard mask in a semiconductor substrate by using the cleaning composition for semiconductor substrates according to any one of items <1> to <17>.
<24> A method for stabilizing hydrogen peroxide, comprising using at least one hydrogen peroxide stabilizing agent (B) selected from the group consisting of oxalic acid, diethylenetriaminepentaacetic acid, hydroxyethyliminodiacetic acid, potassium oxalate, 5-phenyl-1H-tetrazole, triethylenetetraminehexaacetic acid, trans-1,2-cyclohexanediaminetetraacetic acid, 8-quinolinol, L(+)-isoleucine, DL-valine, L(-)-proline, hydroxyethylethylenediaminetriacetic acid, N,N-di(2-hydroxyethyl)glycine, glycine, L-tryptophan, 2,6-pyridinedicarboxylic acid, benzothiazole, and DL-alanine, in a liquid containing hydrogen peroxide (A), cobalt ions, copper ions and water, to thereby stabilize hydrogen peroxide (A).
<25> The method for stabilizing hydrogen peroxide according to item <24>, wherein the liquid containing hydrogen peroxide (A), cobalt ions, copper ions and water has a pH of 7 to 12.
<26> A method for stabilizing hydrogen peroxide, comprising using at least one hydrogen peroxide stabilizing agent (B) selected from the group consisting of oxalic acid, diethylenetriaminepentaacetic acid, hydroxyethyliminodiacetic acid, potassium oxalate, 5-phenyl-1H-tetrazole, triethylenetetraminehexaacetic acid, trans-1,2-cyclohexanediaminetetraacetic acid, 8-quinolinol, L(+)-isoleucine, DL-valine, L(-)-proline, hydroxyethylethylenediaminetriacetic acid, N,N-di(2-hydroxyethyl)glycine, glycine, L-tryptophan, 2,6-pyridinedicarboxylic acid, benzothiazole, and DL-alanine, in a liquid containing hydrogen peroxide (A), ions of at least one metal selected from the group consisting of group IV elements, group V elements, group VI elements, group VII elements, group VIII elements, magnesium and aluminum, cobalt ions and water, to thereby stabilize hydrogen peroxide (A).
<27> The method for stabilizing hydrogen peroxide according to item <26>, wherein the liquid containing hydrogen peroxide (A), ions of at least one metal selected from the group consisting of group IV elements, group V elements, group VI elements, group VII elements, group VIII elements, magnesium and aluminum, cobalt ions and water, has a pH of 7 to 12.
<28> A method for producing a semiconductor substrate, comprising a step of removing at least one selected from the group consisting of dry etching residues and a hard mask in the semiconductor substrates, by using the cleaning composition for semiconductor substrates according to any one of items <1> to <17>.

### [Advantageous Effects of Invention]

The cleaning composition for semiconductor substrates of the present invention has high stability of hydrogen peroxide even under coexistence of a plurality of metals including cobalt, so that cleaning for a long time and repeated use of a cleaning liquid can be performed.

In particular, the cleaning composition for semiconductor substrates of the present invention has high stability of hydrogen peroxide even under coexistence of copper and cobalt, so that cleaning for a long time and repeated use of a cleaning liquid can be performed.

Further, the cleaning composition for semiconductor substrates of the present invention has high stability of hydrogen peroxide even under coexistence of at least one metal selected from the group consisting of group IV elements, group V elements, group VI elements, group VII elements, group VIII elements, magnesium and aluminum, and of cobalt, so that cleaning for a long time and repeated use of a cleaning liquid can be performed.

### [Description of Embodiments]

The present invention is a cleaning composition for semiconductor substrates comprising hydrogen peroxide (A), a hydrogen peroxide stabilizing agent (B), an alkaline compound (C), and water, wherein the hydrogen peroxide stabilizing agent (B) is at least one selected from the group consisting of oxalic acid, diethylenetriaminepentaacetic acid, hydroxyethyliminodiacetic acid, potassium oxalate, 5-phenyl-1H-tetrazole, triethylenetetraminehexaacetic acid, trans-1,2-cyclohexanediaminetetraacetic acid, 8-quinolinol, L(+)-isoleucine, DL-valine, L(-)-proline, hydroxyethylethylenediaminetriacetic acid, N,N-di(2-hydroxyethyl)glycine, glycine, L-tryptophan, 2,6-pyridinedicarboxylic acid, benzothiazole and DL-alanine, and the alkaline compound (C) is at least one selected from the group consisting of a quaternary ammonium hydroxide (C1) and potassium hydroxide (C2); a cleaning method and a production method of a semiconductor substrate using the cleaning composition for semiconductor substrates; and a method for stabilizing hydrogen peroxide comprising using the hydrogen peroxide stabilizing agent (B), to thereby stabilize hydrogen peroxide (A).

### [Cleaning composition for semiconductor substrates]

The cleaning composition for semiconductor substrates of the present invention comprises hydrogen peroxide (A), a hydrogen peroxide stabilizing agent (B), an alkaline compound (C), and water, wherein the hydrogen peroxide stabilizing agent (B) is at least one selected from the group consisting of oxalic acid, diethylenetriaminepentaacetic acid, hydroxyethyliminodiacetic acid, potassium oxalate, 5-phenyl-1H-tetrazole, triethylenetetraminehexaacetic acid, trans-1,2-cyclohexanediaminetetraacetic acid, 8-quinolinol, L(+)-isoleucine, DL-valine, L(-)-proline, hydroxyethylethylenediaminetriacetic acid, N,N-di(2-hydroxyethyl)glycine, glycine, L-tryptophan, 2,6-pyridinedicarboxylic acid, benzothiazole, and DL-alanine, and the alkaline compound (C) is at least one selected from the group consisting of a quaternary ammonium hydroxide (C1) and potassium hydroxide (C2).

### <Hydrogen peroxide (A)>

The cleaning composition for semiconductor substrates of the present invention comprises hydrogen peroxide (A).

Hydrogen peroxide (A) is usually in an aqueous solution form with an appropriate concentration and mixed with another component. The concentration of hydrogen peroxide (A) in an aqueous solution of hydrogen peroxide for use in production of the cleaning composition for semiconductor substrates of the present invention is not particularly limited, for example, preferably 10 to 90 mass%, and more preferably 30 to 60 mass% according to industrial standard.

Also, hydrogen peroxide (A) may comprise a stabilizing agent for use in production thereof. The production method of hydrogen peroxide (A) is not limited, and, for example, ones produced by anthraquinone method are suitably used. Also, hydrogen peroxide (A) may be ones purified by passing the liquid through an ion-exchange resin.

From the viewpoint of cleaning performance, the content of hydrogen peroxide (A) is preferably 10 to 30 mass%, and more preferably 10 to 20 mass%, in the cleaning composition for semiconductor substrates.

### <Hydrogen peroxide stabilizing agent (B)>

The cleaning composition for semiconductor substrates of the present invention comprises a hydrogen peroxide stabilizing agent (B), which is at least one selected from the group consisting of oxalic acid, diethylenetriaminepentaacetic acid, hydroxyethyliminodiacetic acid, potassium oxalate, 5-phenyl-1H-tetrazole, triethylenetetraminehexaacetic acid, trans-1,2-cyclohexanediaminetetraacetic acid, 8-quinolinol, L(+)-isoleucine, DL-valine, L(-)-proline, hydroxyethylethylenediaminetriacetic acid, N,N-di(2-hydroxyethyl)glycine, glycine, L-tryptophan, 2,6-pyridinedicarboxylic acid, benzothiazole, and DL-alanine.

The cleaning composition for semiconductor substrates of the present invention comprises the hydrogen peroxide stabilizing agent (B) to achieve high stability of hydrogen peroxide even under coexistence of a plurality of metals including cobalt, so that cleaning for a long time and repeated use can be performed. The cleaning composition for semiconductor substrates of the present invention comprises the hydrogen peroxide stabilizing agent (B) to achieve high stability of hydrogen peroxide under coexistence of copper and cobalt, in particular, so that cleaning for a long time and repeated use can be performed. Further, the cleaning composition for semiconductor substrates of the present invention comprises the hydrogen peroxide stabilizing agent (B) to achieve high stability of hydrogen peroxide even under coexistence of at least one metal selected from the group consisting of group IV elements, group V elements, group VI elements, group VII elements, group VIII elements, magnesium and aluminum, and of cobalt, so that cleaning for a long time and repeated use can be performed.

As a result of study by the present inventors, it has been found that in the case where a plurality of metals including cobalt are present in cleaning of a semiconductor substrate by using a cleaning composition for semiconductor substrates, particularly in the case where both of copper and cobalt are present, in other words, under coexistence of copper and cobalt, the decomposition of hydrogen peroxide particularly tends to occur. Specifically, PTLs 2 to 18 which are conventional art disclose hydrogen peroxide stabilizing agents against metal ions such as copper ions or cobalt ions, but these agents cannot inhibit decomposition of hydrogen peroxide under coexistence of copper ions and cobalt ions.

In contrast, through extensive study, the present inventors have found a cleaning composition for semiconductor substrates, which has high stability of hydrogen peroxide even under coexistence of copper ions and cobalt ions as described above. Further, as described above, the present inventors have found a cleaning composition for semiconductor substrates, which has high stability of hydrogen peroxide even under coexistence of both of ions of at least one metal selected from the group consisting of group IV elements, group V elements, group VI elements, group VII elements, group VIII elements, magnesium and aluminum, and of cobalt ions.

Although the reason why the cleaning composition for semiconductor substrates of the present invention enhances the stability of hydrogen peroxide under coexistence of copper and cobalt, in particular, as described above, is not clear, it is conceivable that the compounds given as examples herein exhibit strong chelating ability for either or both of copper ions and cobalt ions even under coexistence of the two metals and in an alkaline solution due to the structure thereof, particularly due to the balance between an amino group and a carboxy group. Also, although copper ions and cobalt ions independently have a certain degree of capability of decomposing hydrogen peroxide, it has been a problem that simultaneous existence of copper ions and cobalt ions enhances the rate of decomposition as described above. As the mechanism, it is presumed that in addition to the catalytic effect of copper ions and cobalt ions, the presence of copper ions allows a Fenton-like reaction to proceed, so that hydroxy radicals are produced to involve therein. It is presumed that the hydrogen peroxide stabilizing agent (B) of the present invention has a capability for capturing hydroxy radicals in addition to chelating ability, so that the stability of hydrogen peroxide is further enhanced.

The hydrogen peroxide stabilizing agent (B) is at least one selected from the group consisting of oxalic acid, diethylenetriaminepentaacetic acid, hydroxyethyliminodiacetic acid, potassium oxalate, 5-phenyl-1H-tetrazole, triethylenetetraminehexaacetic acid, trans-1,2-cyclohexanediaminetetraacetic acid, 8-quinolinol, L(+)-isoleucine, DL-valine, L(-)-proline, hydroxyethylethylenediaminetriacetic acid, N,N-di(2-hydroxyethyl)glycine, glycine, L-tryptophan, 2,6-pyridinedicarboxylic acid, benzothiazole, and DL-alanine.

Among the hydrogen peroxide stabilizing agents (B), from the viewpoint of suppressing corrosion of metals or the like constituting a semiconductor substrate, at least one selected from the group consisting of oxalic acid, diethylenetriaminepentaacetic acid, hydroxyethyliminodiacetic acid, potassium oxalate, triethylenetetraminehexaacetic acid, trans-1,2-cyclohexanediaminetetraacetic acid, 8-quinolinol, hydroxyethylethylenediaminetriacetic acid, 5-phenyl-1H-tetrazole, N,N-di(2-hydroxyethyl)glycine, and benzothiazole is preferred. From the viewpoint of suppressing corrosion of metals and further improving the stability of hydrogen peroxide, at least one selected from the group consisting of diethylenetriaminepentaacetic acid, hydroxyethyliminodiacetic acid, triethylenetetraminehexaacetic acid, 8-quinolinol, hydroxyethylethylenediaminetriacetic acid, and trans-1,2-cyclohexanediaminetetraacetic acid is more preferred, and trans-1,2-cyclohexanediaminetetraacetic acid is still more preferred.

A semiconductor substrate contains a metal part such as metal wiring. It is presumed that the hydrogen peroxide stabilizing agents (B) particularly indicated herein have peculiar properties of capturing metal ions in a solution without contribution to ionization of metals, so that hydrogen peroxide is stabilized without corrosion of the metal wiring or the like and cleaning performance is enhanced. Further, it is presumed that the stabilizing agents (B) have ability for capturing hydroxy radicals.

Examples of the hydrogen peroxide stabilizing agents (B) include the compounds described above, and hydrates, salts, derivatives which generate these compounds in the cleaning composition may be also used. For example, trans-1,2-cyclohexanediaminetetraacetic acid is preferably used as a monohydrate from the viewpoint of availability and easiness in compounding.

The content of the hydrogen peroxide stabilizing agent (B) in the cleaning composition for semiconductor substrates is preferably 0.0001 to 5 mass%, and more preferably 0.001 to 1 mass%.

In the case of using a specific compound, examples are shown as follows. For example, the content of trans-1,2-cyclohexanediaminetetraacetic acid as trans-1,2-cyclohexanediaminetetraacetic acid monohydrate in the cleaning composition for semiconductor substrates is preferably 0.0001 to 5 mass%, more preferably 0.001 to 1 mass%, still more preferably 0.001 to 0.5 mass%, furthermore preferably 0.002 to 0.3 mass%, furthermore preferably 0.003 to 0.2 mass%, and in view of the balance between cost and effect, furthermore preferably 0.003 to 0.1 mass%, furthermore preferably 0.005 to 0.05 mass%, and furthermore preferably 0.005 to 0.01 mass%. Also, the content of diethylenetriaminepentaacetic acid in the cleaning composition for semiconductor substrates is preferably 0.0001 to 5 mass%, more preferably 0.001 to 1 mass%, still more preferably 0.01 to 1 mass%, furthermore preferably 0.02 to 0.8 mass%, and furthermore preferably 0.02 to 0.1 mass%. The content of hydroxyethyliminodiacetic acid in the cleaning composition for semiconductor substrates is preferably 0.001 to 5 mass%, more preferably 0.01 to 3 mass%, still more preferably 0.05 to 1 mass%, and furthermore preferably 0.05 to 0.5 mass%. The content of triethylenetetraminehexaacetic acid in the cleaning composition for semiconductor substrates is preferably 0.0001 to 5 mass%, more preferably 0.001 to 1 mass%, still more preferably 0.005 to 0.5 mass%, and furthermore preferably 0.01 to 0.1 mass%. The content of 8-quinolinol in the cleaning composition for semiconductor substrates is preferably 0.0001 to 5 mass%, more preferably 0.0005 to 1 mass%, still more preferably 0.001 to 0.1 mass%, and furthermore preferably 0.001 to 0.01 mass%. The content of hydroxyethylethylenediaminetriacetic acid in the cleaning composition for semiconductor substrates is preferably 0.001 to 5 mass%, more preferably 0.01 to 3 mass%, still more preferably 0.05 to 1 mass%, and furthermore preferably 0.05 to 0.5 mass%.

With a content of the hydrogen peroxide stabilizing agent (B) in the range, the cleaning composition for semiconductor substrates of the present invention has high stability of hydrogen peroxide under coexistence of a plurality of metals including cobalt, particularly under coexistence of copper and cobalt, so that cleaning for a long time and repeated use can be achieved. Also, corrosion of metals or the like constituting a semiconductor substrate can be suppressed. Further, the cleaning composition for semiconductor substrates of the present invention has high stability of hydrogen peroxide even under coexistence of at least one metal selected from the group consisting of group IV elements, group V elements, group VI elements, group VII elements, group VIII elements, magnesium and aluminum, and of cobalt, so that cleaning for a long time and repeated use can be performed.

### <Alkaline compound (C)>

The cleaning composition for semiconductor substrates of the present invention comprises an alkaline compound (C).

The alkaline compound (C) is at least one selected from the group consisting of a quaternary ammonium hydroxide (C1) and potassium hydroxide (C2). The alkaline compound (C) effectively removes a hard mask and dry etching residues, so that damages to a low dielectric constant interlayer insulating film and metal wiring can be suppressed. The quaternary ammonium hydroxide (C1) and potassium hydroxide (C2) may be compounded alone or in combination of two or more.

It is particularly preferable that both of the quaternary ammonium hydroxide (C1) and potassium hydroxide (C2) are comprised as the alkaline compound (C).

The quaternary ammonium hydroxide (C1) is not particularly limited, and examples thereof include preferably at least one selected from the group consisting of tetramethylammonium hydroxide, tetraethylammonium hydroxide, tetrapropylammonium hydroxide, tetrabutylammonium hydroxide, and benzyltrimethylammonium hydroxide. From the viewpoints of economic performance and easiness in availability of starting material, at least one selected from the group consisting of tetramethylammonium hydroxide, tetrapropylammonium hydroxide, and benzyltrimethylammonium hydroxide is more preferred, and tetramethylammonium hydroxide is still more preferred.

The content of the quaternary ammonium hydroxide (C1) in the cleaning composition for semiconductor substrates is preferably 0.005 to 10 mass%, more preferably 0.05 to 5 mass%, and still more preferably 0.1 to 3 mass%.

The content of potassium hydroxide (C2) in the cleaning composition for semiconductor substrates is preferably 0.005 to 5 mass%, more preferably 0.01 to 5 mass%, and still more preferably 0.1 to 1 mass%.

With a content of the alkaline compound (C) in the range, the etching rate of titanium and titanium nitride is particularly improved, which is favorable.

### <Aminopolymethylene phosphonic acid (D)>

The cleaning composition for semiconductor substrates of the present invention may comprise an aminopolymethylene phosphonic acid (D).

An aminopolymethylene phosphonic acid (D) contained therein forms a chelate in the presence of copper ions, so that the stability of hydrogen peroxide improves, which is favorable.

It is preferable that the aminopolymethylene phosphonic acid (D) be at least one selected from the group consisting of aminotri(methylenephosphonic acid), ethylenediaminetetra(methylenephosphonic acid), diethylenetriaminepenta(methylenephosphonic acid), and 1,2-propylenediaminetetra(methylenephosphonic acid).

In the case where the cleaning composition for semiconductor substrates of the present invention comprises an aminopolymethylene phosphonic acid (D), the content of the aminopolymethylene phosphonic acid (D) in the cleaning composition for semiconductor substrates is preferably 0.00005 to 0.005 mass%, more preferably 0.0005 to 0.004 mass%, and still more preferably 0.001 to 0.003 mass%.

With a content of the aminopolymethylene phosphonic acid (D) in the range, the stability of hydrogen peroxide can be maintained with reduced cost.

### <Water>

The cleaning composition for semiconductor substrates of the present invention comprises water.

Although the water is not particularly limited, one from which metal ions, organic impurities, particles, etc., are removed by distillation, ion exchange treatment, filtering treatment, various adsorption treatments, etc., is preferred; pure water is more preferred; and ultrapure water is particularly preferred.

The content of water in the cleaning composition for semiconductor substrates is a balance excluding the components shown in the (A) to (D), optional azoles, and other components from the cleaning composition for semiconductor substrates of the present invention, and the content of water in the cleaning composition for semiconductor substrates is preferably 50 mass% or more, more preferably 73 to 89.9385 mass%, still more preferably 75 to 89.798 mass%, furthermore preferably 75 to 85 mass%, and furthermore preferably 80 to 85 mass%. With a water content in the range, the effect of the present invention can be exhibited with improved economic performance.

### <Characteristics of cleaning composition for semiconductor substrates, etc.>

The pH of the cleaning composition for semiconductor substrates of the present invention is preferably 7 to 12, more preferably 7.5 to 11, and still more preferably 8 to 10.

With a pH in the range, the stability of hydrogen peroxide can be maintained high, and also, the cleaning performance can be enhanced.

The measurement of pH may be performed by the method described in Examples.

### (Cleaning composition for semiconductor substrates for use in cleaning semiconductor substrates containing cobalt and copper)

The cleaning composition for semiconductor substrates of the present invention is preferably used for cleaning a semiconductor substrate containing cobalt and copper. In other words, it is preferable that the cleaning composition for semiconductor substrates of the present invention be used for cleaning a semiconductor substrate containing both of cobalt and copper. The cleaning composition for semiconductor substrates of the present invention has high stability of hydrogen peroxide even when used for cleaning a semiconductor substrate containing both of cobalt and copper. Incidentally, cobalt and copper are used as metal wiring or the like of a semiconductor substrate.

In the semiconductor substrate, cobalt and copper may be used as elementary metal (pure metal) or as an alloy thereof.

In the case where 400 ppb by mass of cobalt ions and 1000 ppb by mass of copper ions are added to the total amount of the cleaning composition for semiconductor substrates of the present invention and then the mixture is treated at 50°C for 6 hours, the cleaning composition for semiconductor substrates has a residual ratio of hydrogen peroxide (A) of preferably 50% or more, more preferably 60% or more, still more preferably 70% or more, and furthermore preferably 80% or more, based on the content of hydrogen peroxide before the treatment.

The measurement of the residual ratio of hydrogen peroxide (A) may be performed, for example, by the method described in Examples.

The cleaning composition for semiconductor substrates of the present invention allows hydrogen peroxide to be stably present for a long time even in the case where both of cobalt ions and copper ions in a cleaning liquid, so that the cleaning composition can be used for cleaning a semiconductor substrate for a long time and repeated cleaning of a semiconductor substrate.

In other words, the cleaning composition for semiconductor substrates of the present invention allows hydrogen peroxide to be stably present for a long time even under coexistence of cobalt and copper, so that the cleaning composition can be used for cleaning a semiconductor substrate for a long time and repeated cleaning of a semiconductor substrate.

### (Cleaning composition for semiconductor substrates, for use in cleaning semiconductor substrates containing: at least one metal selected from the group consisting of group IV elements, group V elements, group VI elements, group VII elements, group VIII elements, magnesium and aluminum; and cobalt)

Further, the cleaning composition for semiconductor substrates of the present invention is preferably used for cleaning a semiconductor substrate containing: at least one metal selected from the group consisting of group IV elements, group V elements, group VI elements, group VII elements, group VIII elements, magnesium and aluminum; and cobalt. In other words, the cleaning composition for semiconductor substrates of the present invention is preferably used for cleaning a semiconductor substrate containing both of at least one metal selected from the group consisting of group IV elements, group V elements, group VI elements, group VII elements, group VIII elements, magnesium and aluminum, and of cobalt. The cleaning composition for semiconductor substrates of the present invention has high stability of hydrogen peroxide even when used for cleaning a semiconductor substrate containing both of at least one metal selected from the group consisting of group IV elements, group V elements, group VI elements, group VII elements, group VIII elements, magnesium and aluminum, and of cobalt. At least one metal selected from the group consisting of group IV elements, group V elements, group VI elements, group VII elements, group VIII elements, magnesium and aluminum, and cobalt, are used as material of semiconductor substrates such as metal wiring.

The cleaning composition for semiconductor substrates of the present invention allows hydrogen peroxide to be stably present for a long time even in the case where both of ions of at least one metal selected from the group consisting of group IV elements, group V elements, group VI elements, group VII elements, group VIII elements, magnesium and aluminum, and of cobalt ions in a cleaning liquid, so that the cleaning composition can be used for cleaning a semiconductor substrate for a long time and repeated cleaning of a semiconductor substrate.

In other words, the cleaning composition for semiconductor substrates of the present invention allows hydrogen peroxide to be stably present for a long time even under coexistence of at least one metal selected from the group consisting of group IV elements, group V elements, group VI elements, group VII elements, group VIII elements, magnesium and aluminum, and of cobalt, so that the cleaning composition can be used for cleaning a semiconductor substrate for a long time and repeated cleaning of a semiconductor substrate.

The at least one metal selected from the group consisting of group IV elements, group V elements, group VI elements, group VII elements, group VIII elements, magnesium and aluminum may be used as elementary metal (pure metal) or as an alloy thereof.

It is preferable that the at least one metal selected from the group consisting of group IV elements, group V elements, group VI elements, group VII elements, group VIII elements, magnesium and aluminum be at least one metal selected from the group consisting of titanium, zirconium, hafnium, tantalum, tungsten, manganese, ruthenium, magnesium and aluminum.

The at least one metal selected from the group consisting of titanium, zirconium, hafnium, tantalum, tungsten, manganese, ruthenium, magnesium and aluminum may be used as elementary metal (pure metal) or as an alloy thereof.

### (Cleaning composition for semiconductor substrates for use in cleaning semiconductor substrates having a hard mask containing titanium and titanium nitride)

The cleaning composition for semiconductor substrates of the present invention is preferably used for cleaning a semiconductor substrate having a hard mask containing at least one selected from the group consisting of titanium and titanium nitride, and more preferably used for cleaning a semiconductor substrate having a hard mask containing titanium nitride. Also, use for cleaning a semiconductor substrate having a hard mask made of at least one selected from the group consisting of titanium and titanium nitride is preferred, and use for cleaning a semiconductor substrate having a hard mask made of titanium nitride is more preferred.

### (Other components)

In the cleaning composition for semiconductor substrates of the present invention, components other than the components described above may be compounded in a range without spoiling the purpose of the present invention. For example, a surfactant, defoaming agent, etc., may be added.

In the cleaning composition for semiconductor substrates of the present invention, azoles other than 5-phenyl-1H-tetrazole and benzothiazole may be compounded in a range without spoiling the purpose of the present invention.

As azoles, at least one selected from the group consisting of an imidazole compound, a pyrazole compound, and a triazole compound, is preferred; and a triazole compound is more preferred.

As azoles, in particular, at least one azole selected from the group consisting of 1-methylimidazole, 1-vinylimidazole, 2-phenylimidazole, 2-ethyl-4-imidazole, N-benzyl-2-methylimidazole, 2-methylbenzoimidazole, pyrazole, 4-methylpyrazole, 3,5-dimethylpyrazole, 1H-benzotriazole, 5-methyl-1H-benzotriazole, and 1H-tetrazole, is preferred; at least one azole selected from the group consisting of 1-methylimidazole, pyrazole, 1H-benzotriazole, and 5-methyl-1H-benzotriazole, is more preferred; and 5-methyl-1H-benzotriazole is still more preferred.

Since ammonia and ammonium ions (NH₄⁺) have effect of accelerating the corrosion of copper and cobalt in the cleaning composition for semiconductor substrates of the present invention, substantially not containing both is preferred. Herein, "substantially not containing" means containing none or containing a minor amount without spoiling the effect of the present invention. Specifically, the total amount of ammonia and ammonium ions (NH₄⁺) in the cleaning composition for semiconductor substrates is preferably less than 0.01 mass%, and more preferably less than 10 ppm by mass. Furthermore, preferably both of ammonia and ammonium ions (NH₄⁺) are not contained.

### [Cleaning method]

The cleaning method of the present invention is a cleaning method for cleaning a semiconductor substrate by using the cleaning composition for semiconductor substrates, preferably a cleaning method for cleaning a semiconductor substrate containing a plurality of metals including cobalt by using the cleaning composition for semiconductor substrates.

The cleaning method of the present invention is preferably a cleaning method for cleaning a semiconductor substrate having a hard mask containing at least one selected from the group consisting of titanium and titanium nitride, and more preferably a cleaning method for cleaning a semiconductor substrate having a hard mask containing titanium nitride. Also, a cleaning method for cleaning a semiconductor substrate having a hard mask made of at least one selected from the group consisting of titanium and titanium nitride is preferred, and a cleaning method for cleaning a semiconductor substrate having a hard mask made of titanium nitride is more preferred.

### (Cleaning method for cleaning semiconductor substrates containing cobalt and copper)

Among the cleaning methods described above, the cleaning method for cleaning a semiconductor substrate containing both of cobalt and copper by using the cleaning composition for semiconductor substrates is preferred. Even in the case of cleaning semiconductor substrates containing both of cobalt and copper, the cleaning composition for semiconductor substrates has high stability of hydrogen peroxide. Incidentally, cobalt and copper are used as metal wiring or the like of a semiconductor substrate.

Cobalt and copper may be used as elementary metal (pure metal) or as an alloy thereof.

Also, the cleaning method of the present invention is preferably a cleaning method for cleaning a semiconductor substrate under coexistence of cobalt ions and copper ions by using the cleaning composition for semiconductor substrates.

Since hydrogen peroxide is stably present for a long time even under coexistence of cobalt ions and copper ions, cleaning of a semiconductor substrate for a long time and repeated cleaning of a semiconductor substrate can be also performed.

In the cleaning method of the present invention, cobalt and copper are present as metal wiring or the like of a semiconductor substrate during cleaning, and also as ions dissolved in a cleaning liquid, and as metal residues.

The cleaning method of the present invention is capable of stably maintaining the content of hydrogen peroxide in the cleaning composition for semiconductor substrates for a long time even under coexistence of cobalt ions and copper ions, so that dry etching residues and a hard mask in semiconductor substrates can be efficiently removed. In other words, a cleaning method for removing at least one selected from the group consisting of dry etching residues and a hard mask in semiconductor substrates by using the cleaning composition for semiconductor substrates is preferred.

In the cleaning method of the present invention, the temperature during cleaning is not particularly limited, preferably 20 to 80°C, and more preferably 25 to 70°C. Also, ultrasonic waves may be used during cleaning.

In the cleaning method of the present invention, the cleaning time is not particularly limited, preferably 0.3 to 20 minutes, and more preferably 0.5 to 10 minutes.

In the cleaning method of the present invention, the pH of a cleaning liquid is preferably 7 to 12, more preferably 7.5 to 11, and still more preferably 8 to 10.

In the cleaning method of the present invention, it is preferable that rinsing be further performed with a rinsing liquid containing water, alcohol, etc., after cleaning.

In the cleaning method of the present invention, the method for contacting the cleaning composition for semiconductor substrates of the present invention with a semiconductor substrate is not particularly limited. For example, a method for contacting the cleaning composition for semiconductor substrates of the present invention with a semiconductor substrate by a form such as dripping (single wafer spinning treatment) or spraying (atomizing treatment), or a method for immersing a semiconductor substrate in the cleaning composition for semiconductor substrates of the present invention may be employed. In the present invention, any one of the methods may be employed.

### (Cleaning method for cleaning a semiconductor substrate containing: at least one metal selected from the group consisting of group IV elements, group V elements, group VI elements, group VII elements, group VIII elements, magnesium and aluminum; and cobalt)

Further, a cleaning method for cleaning a semiconductor substrate containing both of at least one metal selected from the group consisting of group IV elements, group V elements, group VI elements, group VII elements, group VIII elements, magnesium and aluminum, and of cobalt, by using the cleaning composition for semiconductor substrates is preferred. The cleaning composition for semiconductor substrates has high stability of hydrogen peroxide even when used for cleaning a semiconductor substrate containing both of at least one metal selected from the group consisting of group IV elements, group V elements, group VI elements, group VII elements, group VIII elements, magnesium and aluminum, and of cobalt. At least one metal selected from the group consisting of group IV elements, group V elements, group VI elements, group VII elements, group VIII elements, magnesium and aluminum, and cobalt, are used as material of semiconductor substrates such as metal wiring.

The at least one metal selected from the group consisting of group IV elements, group V elements, group VI elements, group VII elements, group VIII elements, magnesium and aluminum may be used as elementary metal (pure metal) or as an alloy thereof.

Also, the cleaning method of the present invention is preferably a cleaning method for cleaning a semiconductor substrate by using the cleaning composition for semiconductor substrates under coexistence of ions of at least one metal selected from the group consisting of group IV elements, group V elements, group VI elements, group VII elements, group VIII elements, magnesium and aluminum, and of cobalt ions.

Since hydrogen peroxide is stably present for a long time even under coexistence of ions of at least one metal selected from the group consisting of group IV elements, group V elements, group VI elements, group VII elements, group VIII element, magnesium and aluminum, and of cobalt ions, cleaning of a semiconductor substrate for a long time and repeated cleaning of a semiconductor substrate can be performed.

In the cleaning method of the present invention, at least one metal selected from the group consisting of group IV elements, group V elements, group VI elements, group VII elements, group VIII elements, magnesium and aluminum, and cobalt, are present as material of a semiconductor substrate such as metal wiring during cleaning, and also as ions dissolved in a cleaning liquid, and as metal residues.

The cleaning method of the present invention is capable of stably maintaining the content of hydrogen peroxide in the cleaning composition for semiconductor substrates for a long time even under coexistence of ions of at least one metal selected from the group consisting of group IV elements, group V elements, group VI elements, group VII elements, group VIII elements, magnesium and aluminum, and of cobalt ions, so that dry etching residues and a hard mask in semiconductor substrates can be efficiently removed. In other words, a cleaning method for removing at least one selected from the group consisting of dry etching residues and a hard mask in semiconductor substrates by using the cleaning composition for semiconductor substrates is preferred.

In the cleaning method of the present invention, it is preferable that the at least one metal selected from the group consisting of group IV elements, group V elements, group VI elements, group VII elements, group VIII elements, magnesium and aluminum be at least one metal selected from the group consisting of titanium, zirconium, hafnium, tantalum, tungsten, manganese, ruthenium, magnesium and aluminum.

The at least one metal selected from the group consisting of titanium, zirconium, hafnium, tantalum, tungsten, manganese, ruthenium, magnesium and aluminum may be used as elementary metal (pure metal) or as an alloy thereof.

In the cleaning method of the present invention, the temperature during cleaning is not particularly limited, preferably 20 to 80°C, and more preferably 25 to 70°C. Also, ultrasonic waves may be used during cleaning.

In the cleaning method of the present invention, the cleaning time is not particularly limited, preferably 0.3 to 20 minutes, and more preferably 0.5 to 10 minutes.

In the cleaning method of the present invention, the pH of a cleaning liquid is preferably 7 to 12, more preferably 7.5 to 11, and still more preferably 8 to 10.

In the cleaning method of the present invention, it is preferable that rinsing be further performed with a rinsing liquid containing water, alcohol, etc., after cleaning.

In the cleaning method of the present invention, the method for contacting the cleaning composition for semiconductor substrates of the present invention with a semiconductor substrate is not particularly limited. For example, a method for contacting the cleaning composition for semiconductor substrates of the present invention with a semiconductor substrate by a form such as dripping (single wafer spinning treatment) or spraying (atomizing treatment), or a method for immersing a semiconductor substrate in the cleaning composition for semiconductor substrates of the present invention may be employed. In the present invention, any one of the methods may be employed.

### [Production method of semiconductor substrate]

A production method of a semiconductor substrate of the present invention comprises a step of removing at least one selected from the group consisting of dry etching residues and a hard mask in the semiconductor substrates, by using the cleaning composition for semiconductor substrates. The specific production method of a semiconductor substrate is shown as follows.

First, on a substrate of silicon or the like having a barrier metal, metal wiring, a low dielectric constant interlayer insulating film, and a cap metal as needed, a barrier insulating film, a low dielectric constant interlayer insulating film, a hard mask and a photo resist are laminated, and then selective exposure and development are applied to the photo resist to form a photo resist pattern. Subsequently, the photo resist pattern is transferred on the hard mask by dry etching. The photo resist pattern is then removed, and using the hard mask as an etching mask, dry etching is applied to the low dielectric constant interlayer insulating film and the barrier insulating film. Subsequently, the step of removing at least one selected from the group consisting of dry etching residues and a hard mask in the semiconductor substrate described above is performed by using the cleaning composition for semiconductor substrates to obtain a semiconductor substrate having a desired metal wiring pattern.

Examples of the substrate material for use include silicon, amorphous silicon, polysilicon, and glass. Examples of the barrier metal for use include tantalum, tantalum nitride, ruthenium, manganese, magnesium, cobalt, and oxides thereof. Examples of the metal wiring for use include copper or a copper alloy, copper or a copper alloy with cobalt or a cobalt alloy formed thereon as a cap metal, and cobalt or a cobalt alloy. Examples of the low dielectric constant interlayer insulating film for use include polysiloxane-based OCD (trade name, manufactured by Tokyo Ohka Kogyo Co., Ltd.) and carbon-doped silicon oxide (SiOC)-based Black Diamond (trade name, manufactured by Applied Materials).

Examples of the barrier insulating film for use include silicon nitride, silicon carbide, and silicon nitride carbide. Examples of the hard mask for use include titanium and titanium nitride.

Since the production method of a semiconductor substrate of the present invention has a step of removing unnecessary components by using the cleaning composition for semiconductor substrates, a semiconductor substrate having high precision and high quality can be produced at a high yield rate.

### [Stabilization method of hydrogen peroxide]

The cleaning composition for semiconductor substrates of the present invention is capable of suppressing decomposition of hydrogen peroxide (A) even under presence of a plurality of metals including cobalt during cleaning, so that the content of hydrogen peroxide (A) can be stably maintained for a long period. The effect can be exhibited by using the hydrogen peroxide stabilizing agent (B), in particular.

### (Method for stabilizing hydrogen peroxide in liquid containing cobalt ions and copper ions)

As described above, the cleaning composition for semiconductor substrates of the present invention is capable of suppressing decomposition of hydrogen peroxide (A) even under coexistence of cobalt and copper during cleaning, so that the content of hydrogen peroxide (A) can be stably maintained for a long period. The effect can be exhibited by using the hydrogen peroxide stabilizing agent (B), in particular.

In other words, the stabilization method of hydrogen peroxide of the present invention is a stabilization method of hydrogen peroxide, in which hydrogen peroxide (A) is stabilized in a liquid comprising hydrogen peroxide (A), cobalt ions, copper ions and water, by at least one hydrogen peroxide stabilizing agent (B) selected from the group consisting of oxalic acid, diethylenetriaminepentaacetic acid, hydroxyethyliminodiacetic acid, potassium oxalate, 5-phenyl-1H-tetrazole, triethylenetetraminehexaacetic acid, trans-1,2-cyclohexanediaminetetraacetic acid, 8-quinolinol, L(+)-isoleucine, DL-valine, L(-)-proline, hydroxyethylethylenediaminetriacetic acid, N,N-di(2-hydroxyethyl)glycine, glycine, L-tryptophan, 2,6-pyridinedicarboxylic acid, benzothiazole, and DL-alanine.

In the stabilization method of hydrogen peroxide of the present invention, the hydrogen peroxide stabilizing agent (B) is at least one selected from the group consisting of oxalic acid, diethylenetriaminepentaacetic acid, hydroxyethyliminodiacetic acid, potassium oxalate, 5-phenyl-1H-tetrazole, triethylenetetraminehexaacetic acid, trans-1,2-cyclohexanediaminetetraacetic acid, 8-quinolinol, L(+)-isoleucine, DL-valine, L(-)-proline, hydroxyethylethylenediaminetriacetic acid, N,N-di(2-hydroxyethyl)glycine, glycine, L-tryptophan, 2,6-pyridinedicarboxylic acid, benzothiazole, and DL-alanine; preferably at least one selected from the group consisting of oxalic acid, diethylenetriaminepentaacetic acid, hydroxyethyliminodiacetic acid, potassium oxalate, triethylenetetraminehexaacetic acid, trans-1,2-cyclohexanediaminetetraacetic acid, 8-quinolinol, hydroxyethylethylenediaminetriacetic acid, 5-phenyl-1H-tetrazole, N,N-di(2-hydroxyethyl)glycine, and benzothiazole; more preferably at least one selected from the group consisting of diethylenetriaminepentaacetic acid, triethylenetetraminehexaacetic acid, and trans-1,2-cyclohexanediaminetetraacetic acid; and still more preferably trans-1,2-cyclohexanediaminetetraacetic acid.

The amount of the hydrogen peroxide stabilizing agent (B) used in a liquid containing hydrogen peroxide (A), cobalt ions, copper ions and water for use in the stabilization method of hydrogen peroxide of the present invention is preferably 0.0001 to 5 mass%, and more preferably 0.001 to 1 mass%.

In the case of using a specific compound, examples are shown as follows. For example, the amount of trans-1,2-cyclohexanediaminetetraacetic acid as trans-1,2-cyclohexanediaminetetraacetic acid monohydride used in a liquid containing hydrogen peroxide (A), cobalt ions, copper ions and water for use in the stabilization method of hydrogen peroxide of the present invention is preferably 0.0001 to 5 mass%, more preferably 0.001 to 1 mass%, still more preferably 0.001 to 0.5 mass%, furthermore preferably 0.002 to 0.3 mass%, furthermore preferably 0.003 to 0.2 mass%, and in consideration of the balance between cost and effect, furthermore preferably 0.003 to 0.1 mass%, furthermore preferably 0.005 to 0.05 mass%, and furthermore preferably 0.005 to 0.01 mass%. Also, the amount of diethylenetriaminepentaacetic acid used in a liquid containing hydrogen peroxide (A), cobalt ions, copper ions and water for use in the stabilization method of hydrogen peroxide of the present invention is preferably 0.0001 to 5 mass%, more preferably 0.001 to 1 mass%, still more preferably 0.01 to 1 mass%, furthermore preferably 0.02 to 0.8 mass%, and furthermore preferably 0.02 to 0.1 mass%. The amount of hydroxyethyliminodiacetic acid used in a liquid containing hydrogen peroxide (A), cobalt ions, copper ions and water for use in the stabilization method of hydrogen peroxide of the present invention is preferably 0.001 to 5 mass%, more preferably 0.01 to 3 mass%, still more preferably 0.05 to 1 mass%, and furthermore preferably 0.05 to 0.5 mass%. The amount of triethylenetetraminehexaacetic acid used in a liquid containing hydrogen peroxide (A), cobalt ions, copper ions and water for use in the stabilization method of hydrogen peroxide of the present invention is preferably 0.0001 to 5 mass%, more preferably 0.001 to 1 mass%, still more preferably 0.005 to 0.5 mass%, and furthermore preferably 0.01 to 0.1 mass%. The amount of 8-quinolinol used in a liquid containing hydrogen peroxide (A), cobalt ions, copper ions and water for use in the stabilization method of hydrogen peroxide of the present invention is preferably 0.0001 to 5 mass%, more preferably 0.0005 to 1 mass%, still more preferably 0.001 to 0.1 mass%, and furthermore preferably 0.001 to 0.01 mass%. The amount of hydroxyethylethylenediaminetriacetic acid used in a liquid containing hydrogen peroxide (A), cobalt ions, copper ions and water for use in the stabilization method of hydrogen peroxide of the present invention is preferably 0.001 to 5 mass%, more preferably 0.01 to 3 mass%, still more preferably 0.05 to 1 mass%, and furthermore preferably 0.05 to 0.5 mass%.

In the stabilization method of hydrogen peroxide of the present invention, the amount of hydrogen peroxide (A) used is not limited, and in a liquid containing hydrogen peroxide (A), cobalt ions, copper ions and water for use in the stabilization method of hydrogen peroxide of the present invention, preferably 10 to 30 mass%, and more preferably 10 to 20 mass%.

In the stabilization method of hydrogen peroxide of the present invention, the pH of the liquid containing hydrogen peroxide (A), cobalt ions, copper ions and water is preferably 7 to 12, more preferably 7.5 to 11, and still more preferably 8 to 10.

### (Method for stabilizing hydrogen peroxide in liquid containing hydrogen peroxide (A), ions of at least one metal selected from the group consisting of group IV elements, group V elements, group VI elements, group VII elements, group VIII elements, magnesium and aluminum, and cobalt ions)

As described above, the cleaning composition for semiconductor substrates of the present invention is capable of suppressing decomposition of hydrogen peroxide (A) even under coexistence of at least one metal selected from the group consisting of group IV elements, group V elements, group VI elements, group VII elements, group VIII elements, magnesium and aluminum, and of cobalt during cleaning, so that the content of hydrogen peroxide (A) can be stably maintained for a long period. The effect can be exhibited by using the hydrogen peroxide stabilizing agent (B), in particular.

In other words, the stabilization method of hydrogen peroxide of the present invention is a stabilization method of hydrogen peroxide, in which hydrogen peroxide (A) is stabilized in a liquid containing hydrogen peroxide (A), ions of at least one metal selected from the group consisting of group IV elements, group V elements, group VI elements, group VII elements, group VIII elements, magnesium and aluminum, cobalt ions and water, by at least one hydrogen peroxide stabilizing agent (B) selected from the group consisting of oxalic acid, diethylenetriaminepentaacetic acid, hydroxyethyliminodiacetic acid, potassium oxalate, 5-phenyl-1H-tetrazole, triethylenetetraminehexaacetic acid, trans-1,2-cyclohexanediaminetetraacetic acid, 8-quinolinol, L(+)-isoleucine, DL-valine, L(-)-proline, hydroxyethylethylenediaminetriacetic acid, N,N-di(2-hydroxyethyl)glycine, glycine, L-tryptophan, 2,6-pyridinedicarboxylic acid, benzothiazole, and DL-alanine.

In the stabilization method of hydrogen peroxide of the present invention, the hydrogen peroxide stabilizing agent (B) is at least one selected from the group consisting of oxalic acid, diethylenetriaminepentaacetic acid, hydroxyethyliminodiacetic acid, potassium oxalate, 5-phenyl-1H-tetrazole, triethylenetetraminehexaacetic acid, trans-1,2-cyclohexanediaminetetraacetic acid, 8-quinolinol, L(+)-isoleucine, DL-valine, L(-)-proline, hydroxyethylethylenediaminetriacetic acid, N,N-di(2-hydroxyethyl)glycine, glycine, L-tryptophan, 2,6-pyridinedicarboxylic acid, benzothiazole, and DL-alanine; preferably at least one selected from the group consisting of oxalic acid, diethylenetriaminepentaacetic acid, hydroxyethyliminodiacetic acid, potassium oxalate, triethylenetetraminehexaacetic acid, trans-1,2-cyclohexanediaminetetraacetic acid, 8-quinolinol, hydroxyethylethylenediaminetriacetic acid, 5-phenyl-1H-tetrazole, N,N-di(2-hydroxyethyl)glycine, and benzothiazole; more preferably at least one selected from the group consisting of diethylenetriaminepentaacetic acid, triethylenetetraminehexaacetic acid, and trans-1,2-cyclohexanediaminetetraacetic acid; and still more preferably trans-1,2-cyclohexanediaminetetraacetic acid.

The amount of the hydrogen peroxide stabilizing agent (B) used in a liquid containing hydrogen peroxide (A), ions of at least one metal selected from the group consisting of group IV elements, group V elements, group VI elements, group VII elements, group VIII elements, magnesium and aluminum, cobalt ions and water for use in the stabilization method of hydrogen peroxide of the present invention is preferably 0.0001 to 5 mass%, and more preferably 0.001 to 1 mass%.

In the case of using a specific compound, examples are shown as follows. For example, the amount of trans-1,2-cyclohexanediaminetetraacetic acid as trans-1,2-cyclohexanediaminetetraacetic acid monohydride used in a liquid containing hydrogen peroxide (A), ions of at least one metal selected from the group consisting of group IV elements, group V elements, group VI elements, group VII elements, group VIII elements, magnesium and aluminum, cobalt ions and water for use in the stabilization method of hydrogen peroxide of the present invention is preferably 0.0001 to 5 mass%, more preferably 0.001 to 1 mass%, still more preferably 0.001 to 0.5 mass%, furthermore preferably 0.002 to 0.3 mass%, furthermore preferably 0.003 to 0.2 mass%, and in consideration of the balance between cost and effect, furthermore preferably 0.003 to 0.1 mass%, furthermore preferably 0.005 to 0.05 mass%, and furthermore preferably 0.005 to 0.01 mass%. Also, the amount of diethylenetriaminepentaacetic acid used in a liquid containing hydrogen peroxide (A), ions of at least one metal selected from the group consisting of group IV elements, group V elements, group VI elements, group VII elements, group VIII elements, magnesium and aluminum, cobalt ions and water for use in the stabilization method of hydrogen peroxide of the present invention is preferably 0.0001 to 5 mass%, more preferably 0.001 to 1 mass%, still more preferably 0.01 to 1 mass%, furthermore preferably 0.02 to 0.8 mass%, and furthermore preferably 0.02 to 0.1 mass%. The amount of hydroxyethyliminodiacetic acid used in a liquid containing hydrogen peroxide (A), ions of at least one metal selected from the group consisting of group IV elements, group V elements, group VI elements, group VII elements, group VIII elements, magnesium and aluminum, cobalt ions and water for use in the stabilization method of hydrogen peroxide of the present invention is preferably 0.001 to 5 mass%, more preferably 0.01 to 3 mass%, still more preferably 0.05 to 1 mass%, and furthermore preferably 0.05 to 0.5 mass%. The amount of triethylenetetraminehexaacetic acid used in a liquid containing hydrogen peroxide (A), ions of at least one metal selected from the group consisting of group IV elements, group V elements, group VI elements, group VII elements, group VIII elements, magnesium and aluminum, cobalt ions and water for use in the stabilization method of hydrogen peroxide of the present invention is preferably 0.0001 to 5 mass%, more preferably 0.001 to 1 mass%, still more preferably 0.005 to 0.5 mass%, and furthermore preferably 0.01 to 0.1 mass%. The amount of 8-quinolinol used in a liquid containing hydrogen peroxide (A), ions of at least one metal selected from the group consisting of group IV elements, group V elements, group VI elements, group VII elements, group VIII elements, magnesium and aluminum, cobalt ions and water for use in the stabilization method of hydrogen peroxide of the present invention is preferably 0.0001 to 5 mass%, more preferably 0.0005 to 1 mass%, still more preferably 0.001 to 0.1 mass%, and furthermore preferably 0.001 to 0.01 mass%. The amount of hydroxyethylethylenediaminetriacetic acid used in a liquid containing hydrogen peroxide (A), ions of at least one metal selected from the group consisting of group IV elements, group V elements, group VI elements, group VII elements, group VIII elements, magnesium and aluminum, cobalt ions and water for use in the stabilization method of hydrogen peroxide of the present invention is preferably 0.001 to 5 mass%, more preferably 0.01 to 3 mass%, still more preferably 0.05 to 1 mass%, and furthermore preferably 0.05 to 0.5 mass%.

In the stabilization method of hydrogen peroxide of the present invention, the amount of hydrogen peroxide (A) used is not limited, and in a liquid containing hydrogen peroxide (A), ions of at least one metal selected from the group consisting of group IV elements, group V elements, group VI elements, group VII elements, group VIII elements, magnesium and aluminum, cobalt ions and water for use in the stabilization method of hydrogen peroxide of the present invention, preferably 10 to 30 mass%, and more preferably 10 to 20 mass%.

In the stabilization method of hydrogen peroxide of the present invention, the pH of the liquid containing hydrogen peroxide (A), ions of at least one metal selected from the group consisting of group IV elements, group V elements, group VI elements, group VII elements, group VIII elements, magnesium and aluminum, cobalt ions and water is preferably 7 to 12, more preferably 7.5 to 11, and still more preferably 8 to 10.

### [Examples]

The present invention is further described in detail with reference to Examples as follows, though the present invention is not limited thereto.

### <Analysis method and evaluation method (1)>

### (1) pH

The pH of a cleaning composition for semiconductor substrates was measured by glass electrode method (F-55S desktop pH meter manufactured by HORIBA, standard ToupH electrode 9165S-10D manufactured by HORIBA, temperature: 25°C).

### (2) Evaluation on stability of hydrogen peroxide

As substitutes of metal residues mixed after cleaning semiconductor substrates, each of standard solutions of copper ions and cobalt ions (ICP standard solutions Cu1000 (1000 ppm by mass) and Co1000 (1000 ppm by mass), manufactured by FUJIFILM Wako Pure Chemical Corporation) was added to cleaning compositions for semiconductor substrates in Examples and Comparative Examples, to satisfy the amount shown in Tables 1 to 5. The amount of hydrogen peroxide immediately after the addition and the amount of hydrogen peroxide after warming at 50°C for 6 hours were measured according to the method described in JIS K1463:2007 with use of potassium permanganate to obtain the residual ratio of hydrogen peroxide (unit: %). The stability of hydrogen peroxide increases with increase in the residual ratio of hydrogen peroxide.

### (3) Evaluation on corrosion of metal

A silicon wafer having electroplated copper with a thickness of 6000 angstrom deposited on a PVD seed layer with a thickness of 600 angstrom and annealed, and a silicon wafer having cobalt with a thickness of 2000 angstrom deposited by PVD (manufactured by Advantec Co., Ltd.) were subjected to film thickness measurement by fluorescent X-ray analysis (SEA 1200VX manufactured by Hitachi, Ltd.), and then immersed in the cleaning composition for semiconductor substrates at 50°C for a predetermined time (copper: 60 minutes, cobalt: 5 minutes). The silicon wafers were then rinsed with ultrapure water at room temperature, and subjected to film thickness measurement by fluorescent X-ray analysis again, so that the amounts of film thickness of copper and cobalt reduced in a unit time were measured.

The measurement results were evaluated based on the following criteria.
A: The amount of film thickness of copper reduced is 1 angstrom/minute or less. The amount of film thickness of cobalt reduced is 3 angstrom/minute or less.
B: The amount of film thickness of copper reduced is more than 1 angstrom/minute and 2 angstrom/minute or less. The amount of film thickness of cobalt reduced is more than 3 angstrom/minute and 10 angstrom/minute or less.
C: The amount of film thickness of copper reduced is more than 2 angstrom/minute. The amount of film thickness of cobalt reduced is more than 10 angstrom/minute.

### <Cleaning composition for semiconductor substrates>

### Example 1

A cleaning composition for semiconductor substrates was obtained by compounding 15 parts by mass of hydrogen peroxide (48.39 parts by mass of 31% hydrogen peroxide aqueous solution was compounded to satisfy the amount of active ingredient described above), 0.15 parts by mass of potassium hydroxide, 0.5 parts by mass of tetramethylammonium hydroxide, and 0.005 parts by mass of trans-1,2-cyclohexanediaminetetraacetic acid monohydrate as a hydrogen peroxide stabilizing agent (B), and diluting the mixture with ultrapure water to make 100 parts by mass of the total. The evaluation shown in Table 1 was performed. In each of tables, the amount of each component compounded is shown in terms of "mass%".

### Example 2

A cleaning composition for semiconductor substrates was obtained by compounding 20 parts by mass of hydrogen peroxide (64.52 parts by mass of 31% hydrogen peroxide aqueous solution was compounded to satisfy the amount of active ingredient described above), 0.15 parts by mass of potassium hydroxide, 0.5 parts by mass of tetramethylammonium hydroxide, and 0.005 parts by mass of trans-1,2-cyclohexanediaminetetraacetic acid monohydrate as a hydrogen peroxide stabilizing agent (B), and diluting the mixture with ultrapure water to make 100 parts by mass of the total. The evaluation shown in Table 1 was performed.

### Example 3

A cleaning composition for semiconductor substrates was obtained by compounding 25 parts by mass of hydrogen peroxide (80.65 parts by mass of 31% hydrogen peroxide aqueous solution was compounded to satisfy the amount of active ingredient described above), 0.15 parts by mass of potassium hydroxide, 0.5 parts by mass of tetramethylammonium hydroxide, and 0.005 parts by mass of trans-1,2-cyclohexanediaminetetraacetic acid monohydrate as a hydrogen peroxide stabilizing agent (B), and diluting the mixture with ultrapure water to make 100 parts by mass of the total. The evaluation shown in Table 1 was performed.

### Example 4

A cleaning composition for semiconductor substrates was obtained by compounding 15 parts by mass of hydrogen peroxide (48.39 parts by mass of 31% hydrogen peroxide aqueous solution was compounded to satisfy the amount of active ingredient described above), 0.30 parts by mass of potassium hydroxide, 0.5 parts by mass of tetramethylammonium hydroxide, and 0.005 parts by mass of trans-1,2-cyclohexanediaminetetraacetic acid monohydrate as a hydrogen peroxide stabilizing agent (B), and diluting the mixture with ultrapure water to make 100 parts by mass of the total. The evaluation shown in Table 1 was performed.

### Example 5

A cleaning composition for semiconductor substrates was obtained by compounding 15 parts by mass of hydrogen peroxide (48.39 parts by mass of 31% hydrogen peroxide aqueous solution was compounded to satisfy the amount of active ingredient described above), 0.15 parts by mass of potassium hydroxide, 1.0 parts by mass of tetramethylammonium hydroxide, and 0.005 parts by mass of trans-1,2-cyclohexanediaminetetraacetic acid monohydrate as a hydrogen peroxide stabilizing agent (B), and diluting the mixture with ultrapure water to make 100 parts by mass of the total. The evaluation shown in Table 1 was performed.

### Example 6

A cleaning composition for semiconductor substrates was obtained by compounding 15 parts by mass of hydrogen peroxide (48.39 parts by mass of 31% hydrogen peroxide aqueous solution was compounded to satisfy the amount of active ingredient described above), 0.15 parts by mass of potassium hydroxide, and 0.005 parts by mass of trans-1,2-cyclohexanediaminetetraacetic acid monohydrate as a hydrogen peroxide stabilizing agent (B), and diluting the mixture with ultrapure water to make 100 parts by mass of the total. The evaluation shown in Table 1 was performed.

### Example 7

A cleaning composition for semiconductor substrates was obtained by compounding 15 parts by mass of hydrogen peroxide (48.39 parts by mass of 31% hydrogen peroxide aqueous solution was compounded to satisfy the amount of active ingredient described above), 0.5 parts by mass of tetramethylammonium hydroxide, and 0.005 parts by mass of trans-1,2-cyclohexanediaminetetraacetic acid monohydrate as a hydrogen peroxide stabilizing agent (B), and diluting the mixture with ultrapure water to make 100 parts by mass of the total. The evaluation shown in Table 1 was performed.

### Example 8

A cleaning composition for semiconductor substrates was obtained by compounding 15 parts by mass of hydrogen peroxide (48.39 parts by mass of 31% hydrogen peroxide aqueous solution was compounded to satisfy the amount of active ingredient described above), 0.15 parts by mass of potassium hydroxide, 0.5 parts by mass of tetraethylammonium hydroxide, and 0.005 parts by mass of trans-1,2-cyclohexanediaminetetraacetic acid monohydrate as a hydrogen peroxide stabilizing agent (B), and diluting the mixture with ultrapure water to make 100 parts by mass of the total. The evaluation shown in Table 1 was performed.

### Example 9

A cleaning composition for semiconductor substrates was obtained by compounding 15 parts by mass of hydrogen peroxide (48.39 parts by mass of 31% hydrogen peroxide aqueous solution was compounded to satisfy the amount of active ingredient described above), 0.15 parts by mass of potassium hydroxide, 0.5 parts by mass of tetrapropylammonium hydroxide, and 0.005 parts by mass of trans-1,2-cyclohexanediaminetetraacetic acid monohydrate as a hydrogen peroxide stabilizing agent (B), and diluting the mixture with ultrapure water to make 100 parts by mass of the total. The evaluation shown in Table 1 was performed.

### Example 10

A cleaning composition for semiconductor substrates was obtained by compounding 15 parts by mass of hydrogen peroxide (48.39 parts by mass of 31% hydrogen peroxide aqueous solution was compounded to satisfy the amount of active ingredient described above), 0.15 parts by mass of potassium hydroxide, 0.5 parts by mass of tetrabutylammonium hydroxide, and 0.005 parts by mass of trans-1,2-cyclohexanediaminetetraacetic acid monohydrate as a hydrogen peroxide stabilizing agent (B), and diluting the mixture with ultrapure water to make 100 parts by mass of the total. The evaluation shown in Table 1 was performed.

### Example 11

A cleaning composition for semiconductor substrates was obtained by compounding 15 parts by mass of hydrogen peroxide (48.39 parts by mass of 31% hydrogen peroxide aqueous solution was compounded to satisfy the amount of active ingredient described above), 0.15 parts by mass of potassium hydroxide, 0.5 parts by mass of benzyltrimethylammonium hydroxide, and 0.005 parts by mass of trans-1,2-cyclohexanediaminetetraacetic acid monohydrate as a hydrogen peroxide stabilizing agent (B), and diluting the mixture with ultrapure water to make 100 parts by mass of the total. The evaluation shown in Table 1 was performed.

### Example 12

A cleaning composition for semiconductor substrates was obtained by compounding 15 parts by mass of hydrogen peroxide (48.39 parts by mass of 31% hydrogen peroxide aqueous solution was compounded to satisfy the amount of active ingredient described above), 0.15 parts by mass of potassium hydroxide, 0.5 parts by mass of tetramethylammonium hydroxide, 0.002 parts by mass of aminotri(methylenephosphonic acid), and 0.005 parts by mass of trans-1,2-cyclohexanediaminetetraacetic acid monohydrate as a hydrogen peroxide stabilizing agent (B), and diluting the mixture with ultrapure water to make 100 parts by mass of the total. The evaluation shown in Table 1 was performed.

### Example 13

A cleaning composition for semiconductor substrates was obtained by compounding 15 parts by mass of hydrogen peroxide (48.39 parts by mass of 31% hydrogen peroxide aqueous solution was compounded to satisfy the amount of active ingredient described above), 0.15 parts by mass of potassium hydroxide, 0.5 parts by mass of tetramethylammonium hydroxide, 0.002 parts by mass of ethylenediaminetetra(methylenephosphonic acid), and 0.005 parts by mass of trans-1,2-cyclohexanediaminetetraacetic acid monohydrate as a hydrogen peroxide stabilizing agent (B), and diluting the mixture with ultrapure water to make 100 parts by mass of the total. The evaluation shown in Table 1 was performed.

### Example 14

A cleaning composition for semiconductor substrates was obtained by compounding 15 parts by mass of hydrogen peroxide (48.39 parts by mass of 31% hydrogen peroxide aqueous solution was compounded to satisfy the amount of active ingredient described above), 0.15 parts by mass of potassium hydroxide, 0.5 parts by mass of tetramethylammonium hydroxide, 0.002 parts by mass of diethylenetriaminepenta(methylenephosphonic acid), and 0.005 parts by mass of trans-1,2-cyclohexanediaminetetraacetic acid monohydrate as a hydrogen peroxide stabilizing agent (B), and diluting the mixture with ultrapure water to make 100 parts by mass of the total. The evaluation shown in Table 1 was performed.

### Example 15

A cleaning composition for semiconductor substrates was obtained by compounding 15 parts by mass of hydrogen peroxide (48.39 parts by mass of 31% hydrogen peroxide aqueous solution was compounded to satisfy the amount of active ingredient described above), 0.15 parts by mass of potassium hydroxide, 0.5 parts by mass of tetramethylammonium hydroxide, 0.002 parts by mass of 1,2-propylenediaminetetra(methylenephosphonic acid), and 0.005 parts by mass of trans-1,2-cyclohexanediaminetetraacetic acid monohydrate as a hydrogen peroxide stabilizing agent (B), and diluting the mixture with ultrapure water to make 100 parts by mass of the total. The evaluation shown in Table 1 was performed.

### Example 16

A cleaning composition for semiconductor substrates was obtained by compounding 15 parts by mass of hydrogen peroxide (48.39 parts by mass of 31% hydrogen peroxide aqueous solution was compounded to satisfy the amount of active ingredient described above), 0.15 parts by mass of potassium hydroxide, 0.5 parts by mass of tetramethylammonium hydroxide, 0.002 parts by mass of diethylenetriaminepenta(methylenephosphonic acid), and 0.1 parts by mass of trans-1,2-cyclohexanediaminetetraacetic acid monohydrate as a hydrogen peroxide stabilizing agent (B), and diluting the mixture with ultrapure water to make 100 parts by mass of the total. The evaluation shown in Table 1 was performed.

### Example 17

A cleaning composition for semiconductor substrates was obtained by compounding 15 parts by mass of hydrogen peroxide (48.39 parts by mass of 31% hydrogen peroxide aqueous solution was compounded to satisfy the amount of active ingredient described above), 0.15 parts by mass of potassium hydroxide, 0.5 parts by mass of tetramethylammonium hydroxide, 0.002 parts by mass of diethylenetriaminepenta(methylenephosphonic acid), and 0.0001 parts by mass of trans-1,2-cyclohexanediaminetetraacetic acid monohydrate as a hydrogen peroxide stabilizing agent (B), and diluting the mixture with ultrapure water to make 100 parts by mass of the total. The evaluation shown in Table 1 was performed.

### Example 18

A cleaning composition for semiconductor substrates was obtained in the same manner as in Example 14, except that 0.50 parts by mass of tetramethylammonium hydroxide in Example 14 was replaced with 0.50 parts by mass of ammonia and the amount of ultrapure water was adjusted to make 100 parts by mass of the total. The evaluation shown in Table 1 was performed.

### Example 19

A cleaning composition for semiconductor substrates was obtained in the same manner as in Example 14, except that 0.50 parts by mass of tetramethylammonium hydroxide in Example 14 was replaced with 0.50 parts by mass of ammonia, 0.002 parts by mass of 5-methyl-1H-tetrazole was compounded, and the amount of ultrapure water was adjusted to make 100 parts by mass of the total. The evaluation shown in Table 1 was performed.

### Comparative Example 1

A cleaning composition for semiconductor substrates was obtained in the same manner as in Example 16, except that 0.10 parts by mass of trans-1,2-cyclohexanediaminetetraacetic acid monohydrate in Example 16 was not used and the amount of ultrapure water was adjusted to make 100 parts by mass of the total. The evaluation results are shown in Table 1.

### Reference Examples 1 and 2

As reference examples, evaluation on the stability of hydrogen peroxide was performed using the cleaning composition for semiconductor substrates in Comparative Example 1, with addition of cobalt or copper alone. The results are also shown in Table 1.

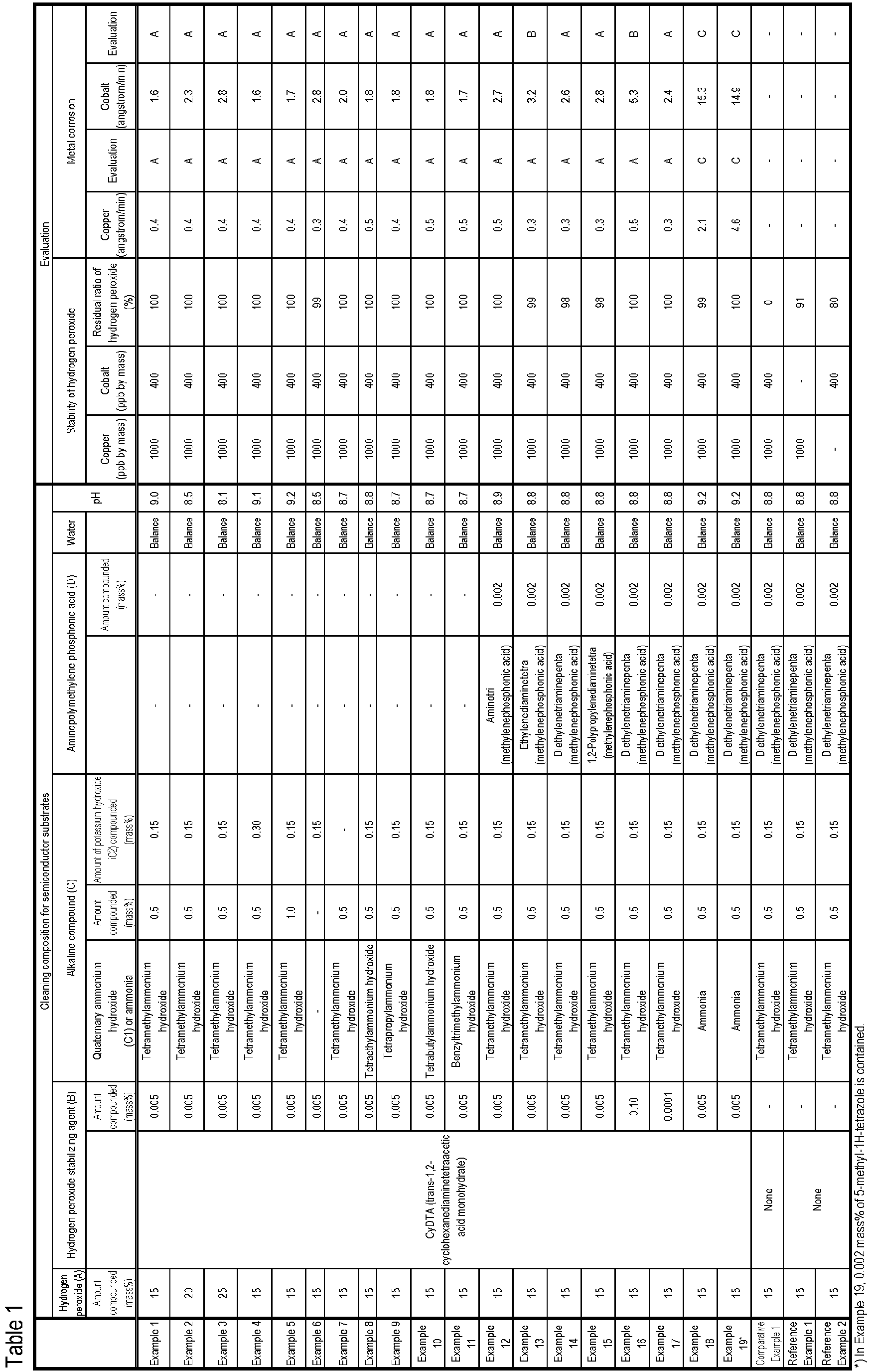

### Examples 20 to 35

Cleaning compositions for semiconductor substrates were obtained in the same manner as in Example 16, except that 0.10 parts by mass of trans-1,2-cyclohexanediaminetetraacetic acid monohydrate in Example 16 was replaced with each of the compounds (compounds of hydrogen peroxide stabilizing agent (B)) and the amount compounded shown in Table 2, and the amount of ultrapure water was adjusted to make 100 parts by mass of the total. The evaluation results are shown in Table 2.

### Example 36

A cleaning composition for semiconductor substrates was obtained in the same manner as in Example 16, except that 0.10 parts by mass of trans-1,2-cyclohexanediaminetetraacetic acid monohydrate in Example 16 was replaced with 0.10 parts by mass of glycine, 0.02 parts by mass of 5-methyl-1H-benzotriazole was compounded, and the amount of ultrapure water was adjusted to make 100 parts by mass of the total. The evaluation results are shown in Table 2.

### Example 37

A cleaning composition for semiconductor substrates was obtained in the same manner as in Example 16, except that 0.02 parts by mass of 5-methyl-1H-benzotriazole in Example 36 was replaced with 1.0 part by mass of pyrazole, and the amount of ultrapure water was adjusted to make 100 parts by mass of the total. The evaluation results are shown in Table 2.

### Example 38

A cleaning composition for semiconductor substrates was obtained in the same manner as in Example 16, except that 0.02 parts by mass of 5-methyl-1H-benzotriazole in Example 36 was replaced with 1.0 part by mass of 1-methylimidazole, and the amount of ultrapure water was adjusted to make 100 parts by mass of the total. The evaluation results are shown in Table 2.

### Example 39

A cleaning composition for semiconductor substrates was obtained in the same manner as in Example 16, except that 0.02 parts by mass of 5-methyl-1H-benzotriazole in Example 36 was replaced with 0.02 parts by mass of 1H-benzotriazole, and the amount of ultrapure water was adjusted to make 100 parts by mass of the total. The evaluation results are shown in Table 2.

**Table 2**

| | Cleaning composition for semiconductor substrates* | | | | | Evaluation | | | | | | |
|---|---|---|---|---|---|---|---|---|---|---|---|---|
| | Compound of hydrogen peroxide stabilizing agent (B) | | Azoles | | | Stability of hydrogen peroxide | | | Metal corrosion | | | |
| | | Amount compounded (mass%) | | Amount compounded (mass%) | pH | Copper (ppb by mass) | Cobalt (ppb by mass) | Residual ratio of hydrogen peroxide (%) | Copper (angstrom/min) | Evaluation | Cobalt (angstrom/min) | Evaluation |
| Example 20 | Oxalic acid | 0.10 | - | - | 8.7 | 1000 | 400 | 71 | 0.1 | A | 2.5 | A |
| Example 21 | Diethylenetriaminepentaacetic acid | 0.05 | - | - | 8.8 | 1000 | 400 | 83 | 0.3 | A | 2.4 | A |
| Example 22 | Hydroxyethyliminodiacetic acid | 0.15 | - | - | 8.8 | 1000 | 400 | 82 | 0.2 | A | 1.5 | A |
| Example 23 | Potassium oxalate monohydrate | 0.37 | - | - | 8.8 | 1000 | 400 | 72 | 0.1 | A | 1.8 | A |
| Example 24 | Triethylenetetraminehexaacetic acid | 0.03 | - | - | 8.8 | 1000 | 400 | 84 | 0.5 | A | 2.6 | A |
| Example 25 | 8-Quinolinol | 0.005 | - | - | 8.8 | 1000 | 400 | 87 | 0.1 | A | 2.8 | A |
| Example 26 | Hydroxyethylethylenediaminetria cetic acid | 0.15 | - | - | 8.8 | 1000 | 400 | 80 | 0.1 | A | 2.5 | A |
| Example 27 | 5-Phenyl-1H-tetrazole | 0.20 | - | - | 8.8 | 1000 | 400 | 61 | 0.2 | A | 1.2 | A |
| Example 28 | L(+)-isoleucine | 0.15 | - | - | 8.8 | 1000 | 400 | 87 | 1.6 | B | 5.1 | B |
| Example 29 | DL-valine | 0.20 | - | - | 8.8 | 1000 | 400 | 76 | 1.8 | B | 5.1 | B |
| Example 30 | L(-)-proline | 0.20 | - | - | 8.8 | 1000 | 400 | 72 | 1.4 | B | 4.9 | B |
| Example 31 | N,N-di(2-hydroxyethyl)glycine | 0.50 | - | - | 8.8 | 1000 | 400 | 71 | 0.2 | A | 1.6 | A |
| Example 32 | L-tryptophan | 0.10 | - | - | 8.8 | 1000 | 400 | 71 | 1.7 | B | 3.4 | B |
| Example 33 | 2,6-Pyridinedicarboxylic acid | 0.10 | - | - | 8.8 | 1000 | 400 | 95 | 1.1 | B | 6.7 | B |
| Example 34 | Benzothiazole | 0.10 | - | - | 8.8 | 1000 | 400 | 60 | 0.1 | A | 1.3 | A |
| Example 35 | DL-alanine | 0.10 | - | - | 8.8 | 1000 | 400 | 72 | 0.9 | A | 7.1 | B |
| Example 36 | Glycine | 0.10 | 5-Methyl-1H-benzotriazole | 0.02 | 8.8 | 1000 | 400 | 76 | 1.9 | B | 8.8 | B |
| Example 37 | Glycine | 0.10 | Pyrazole | 1.0 | 8.8 | 1000 | 400 | 75 | 1.9 | B | 9.8 | B |
| Example 38 | Glycine | 0.10 | 1-Methylimidazole | 1.0 | 8.8 | 1000 | 400 | 76 | 1.5 | B | 9.7 | B |
| Example 39 | Glycine | 0.10 | 1H-Benzotriazole | 0.02 | 8.8 | 1000 | 400 | 77 | 1.7 | B | 9.0 | B |

| | | | | | | | | | | | | |
|---|---|---|---|---|---|---|---|---|---|---|---|---|
| ^{*}*) In the cleaning compositions for semiconductor substrates in Table 2 (Examples 20 to 39), 15 mass% of hydrogen peroxide, 0.15 mass% of potassium hydroxide, 0.5 mass% of tetramethylammonium hydroxide, and 0.002 mass% of diethylenetriaminepenta(methylenephosphonic acid) are contained. | | | | | | | | | | | | |

### Comparative Examples 2 to 22

Cleaning compositions for semiconductor substrates were obtained in the same manner as in Example 16, except that 0.10 parts by mass of trans-1,2-cyclohexanediaminetetraacetic acid monohydrate in Example 16 was replaced with each of the compounds and the amount compounded shown in the compound column of Table 3. The evaluation results are shown in Table 3.

**Table 3**

| | Cleaning composition for semiconductor substrates* | | | Evaluation | | |
|---|---|---|---|---|---|---|
| | Compound | | | Stability of hydrogen peroxide | | |
| | | Amount compounded (mass%) | pH | Copper (ppb by mass) | Cobalt (ppb by mass) | Residual ratio of hydrogen peroxide (%) |
| Comparative Example 2 | Pyrazole | 0.10 | 8.8 | 1000 | 400 | 0 |
| Comparative Example 3 | Benzimidazole | 0.10 | 8.8 | 1000 | 400 | 0 |
| Comparative Example 4 | Adenine | 0.10 | 8.8 | 1000 | 400 | 0 |
| Comparative Example 5 | Taurine | 0.10 | 8.8 | 1000 | 400 | 0 |
| Comparative Example 6 | Caffeine | 0.10 | 8.8 | 1000 | 400 | 13 |
| Comparative Example 7 | 4-Bromo-1H-pyrazole | 0.20 | 8.8 | 1000 | 400 | 35 |
| Comparative Example 8 | 2-Pyridine carboxylic acid | 0.20 | 8.8 | 1000 | 400 | 41 |
| Comparative Example 9 | 4-Pyridine carboxylic acid | 0.10 | 8.8 | 1000 | 400 | 5 |
| Comparative Example 10 | Nicotinic acid | 0.10 | 8.8 | 1000 | 400 | 0 |
| Comparative Example 11 | 2,6-Dihydroxyisonicotinic acid | 0.10 | 8.8 | 1000 | 400 | 0 |
| Comparative Example 12 | Citric acid | 0.10 | 8.8 | 1000 | 400 | 0 |
| Comparative Example 13 | Succinic acid | 0.10 | 8.8 | 1000 | 400 | 0 |
| Comparative Example 14 | Malic acid | 0.10 | 8.8 | 1000 | 400 | 4 |
| Comparative Example 15 | Tartaric acid | 0.10 | 8.8 | 1000 | 400 | 1 |
| Comparative Example 16 | Malonic acid | 0.10 | 8.8 | 1000 | 400 | 5 |
| Comparative Example 17 | Isophthalic acid | 0.10 | 8.8 | 1000 | 400 | 0 |
| Comparative Example 18 | 2,6-Dihydroxyisonicotinic acid | 0.10 | 8.8 | 1000 | 400 | 0 |
| Comparative Example 19 | L-aspartic acid | 0.10 | 8.8 | 1000 | 400 | 2 |
| Comparative Example 20 | L-methionine | 0.10 | 8.8 | 1000 | 400 | 2 |
| Comparative Example 21 | DL-threonine | 0.10 | 8.8 | 1000 | 400 | 0 |
| Comparative Example 22 | Betaine | 0.10 | 8.8 | 1000 | 400 | 7 |

| | | | | | | |
|---|---|---|---|---|---|---|
| *) In the cleaning composition for semiconductor substrates in Table 3 (Comparative Examples 2 to 22), 15 mass% of hydrogen peroxide, 0.15 mass% of potassium hydroxide, 0.5 mass% of tetramethylammonium hydroxide, and 0.002 mass% of diethylenetriaminepenta (methylenephosphonic acid) are contained. | | | | | | |

### Example 40

Into the cleaning composition for semiconductor substrates in Example 14, 1.0 part by mass of 5-methyl-1H-benzotriazole was compounded and sulfuric acid was added thereto to obtain a cleaning composition for semiconductor substrates having a pH of 7. The evaluation results are shown in Table 4.

### Example 41

Into the cleaning composition for semiconductor substrates in Example 16, 5.0 parts by mass of pyrazole was compounded and sodium hydroxide was added thereto to obtain a cleaning composition for semiconductor substrates having a pH of 12. The evaluation results are shown in Table 4.

### Comparative Example 23

Into the cleaning composition for semiconductor substrates in Comparative Example 1, 1.0 part by mass of 5-methyl-1H-benzotriazole was compounded and sulfuric acid was added thereto to obtain a cleaning composition for semiconductor substrates having a pH of 7. The evaluation results are shown in Table 4.

### Comparative Example 24

Into the cleaning composition for semiconductor substrates in Comparative Example 1, 5.0 parts by mass of pyrazole was compounded and sodium hydroxide was added thereto to obtain a cleaning composition for semiconductor substrates having a pH of 12. The evaluation results are shown in Table 4.

**Table 4**

| | Cleaning composition for semiconductor substrates* | | | | | | Evaluation | | | | | | |
|---|---|---|---|---|---|---|---|---|---|---|---|---|---|
| | Hydrogen peroxide stabilizing agent (B) | | Azoles | | pH Adjuster | | Stability of hydrogen peroxide | | | Metal corrosion | | | |
| | | Amount compounder (mass%) | | Amount compounded (mass%) | | pH | Copper (ppb by mass) | Cobalt (ppb by mass) | Residual ratio of hydrogen peroxide (%) | Copper (angstro m/min) | Evaluation | Cobalt (angstro m/min) | Evaluation |
| Example 40 | CyDTA (trans-1 ,2-cyclohexanediaminetetraacetic acid monohydrate) | 0.005 | 5-Methyl-1H-benzotriazole | 1.0 | Sulfuric acid | 7.0 | 1000 | 400 | 100 | 0.1 | A | 9.8 | B |
| | | | | | | | 5000 | 2000 | 100 | | | | |
| Example 41 | | 0.10 | Pyrazole | 5.0 | Sodium hydroxide | 12.0 | 1000 | 400 | 61 | 1.9 | B | 0.4 | A |
| | | | | | | | 2.5 | 1 | 81 | | | | |
| Comparative Example 23 | None | - | 5-Methyl -1H-benzotriazole | 1.0 | Sulfuric acid | 7.0 | 1000 | 400 | 0 | - | - | - | - |
| Comparative Example 24 | | - | Pyrazole | 5.0 | Sodium hydroxide | 12.0 | 2.5 | 1 | 37 | - | - | - | - |

| | | | | | | | | | | | | | |
|---|---|---|---|---|---|---|---|---|---|---|---|---|---|
| *) In the cleaning compositions for semiconductor substrates in Table 4 (Examples 40 and 41, and Comparative Examples 23 and 24), 15 mass% of hydrogen peroxide, 0.15 mass% of potassium hydroxide, 0.5 mass% of tetramethylammonium hydroxide, and 0.002 mass% of diethylenetriaminepenta(methylenephosphonic acid) are contained. | | | | | | | | | | | | | |

### Comparative Examples 25 to 40

Cleaning compositions for semiconductor substrates were obtained in the same manner as in Example 16, except that 0.10 parts by mass of trans-1,2-cyclohexanediaminetetraacetic acid monohydrate in Example 16 was replaced with each of the compounds described in PTLs 2 to 17 and the amount compounded shown in Table 5. The evaluation results are shown in Table 5.

**Table 5**

| | Cleaning composition for semiconductor substrates* | | | Evaluation | | |
|---|---|---|---|---|---|---|
| | Compound | | | Stability of hydrogen peroxide | | |
| | | Amount compounded (mass%) | pH | Copper (ppb by mass) | Cobalt (ppb by mass) | Residual ratio of hydrogen peroxide (%) |
| Comparative Example 25 | DL-serine | 0.10 | 8.8 | 1000 | 400 | 0 |
| Comparative Example 26 | L-glutamic acid | 0.10 | 8.8 | 1000 | 400 | 1 |
| Comparative Example 27 | Phenyl urea | 0.10 | 8.8 | 1000 | 400 | 0 |
| Comparative Example 28 | TEMPO (2,2,6,6-tetramethylpiperidine 1-oxyl) | 0.10 | 8.8 | 1000 | 400 | 0 |
| Comparative Example 29 | N,N,N,N-ethylenediaminetetrakis(methylene phosphonic acid) hydrate | 0.20 | 8.8 | 1000 | 400 | 42 |
| Comparative Example 30 | PDTA (1,3-propanediamine-N,N,N',N'-tetraacetic acid) | 0.10 | 8.8 | 1000 | 400 | 25 |
| Comparative Example 31 | 2-Butoxyethanol | 0.10 | 8.8 | 1000 | 400 | 0 |
| Comparative Example 32 | Uric acid | 0.10 | 8.8 | 1000 | 400 | 12 |
| Comparative Example 33 | p-Toluenesulphonic acid monohydrate | 0.10 | 8.8 | 1000 | 400 | 0 |
| Comparative Example 34 | HEDP | 0.10 | 8.8 | 1000 | 400 | 0 |
| Comparative Example 35 | 2,2',2"-Nitrilotriethanol | 0.10 | 8.8 | 1000 | 400 | 0 |
| Comparative Example 36 | 2-Hydroxyethane sulphonic acid | 0.10 | 8.8 | 1000 | 400 | 0 |
| Comparative Example 37 | p-Phenol sulphonic acid | 0.10 | 8.8 | 1000 | 400 | 0 |
| Comparative Example 38 | 1,2-Propylenediaminetetra(methylenephosphonic acid) | 0.10 | 8.8 | 1000 | 400 | 0 |
| Comparative Example 39 | 2-Mercaptobenzoimidazole | 0.10 | 8.8 | 1000 | 400 | 0 |
| Comparative Example 40 | p-Aminobenzoic acid | 0.10 | 8.8 | 1000 | 400 | 0 |

| | | | | | | |
|---|---|---|---|---|---|---|
| *) In the cleaning compositions for semiconductor substrates in Table 5 (Comparative Examples 25 to 40), 15 mass% of hydrogen peroxide, 0.15 mass% of potassium hydroxide, 0.5 mass% of tetramethylammonium hydroxide, and 0.002 mass% of diethylenetriaminepenta(methylenephosphonic acid) are contained. | | | | | | |

As shown in Tables 1 to 5, it is evident that the cleaning compositions for semiconductor substrates in Examples have high stability of hydrogen peroxide even in the presence of two types of metal ions of copper and cobalt. Further, it is also evident that the cleaning compositions for semiconductor substrates with use of the hydrogen peroxide stabilizing agent shown in Examples cause less corrosion of metals constituting the semiconductor substrate.

### <Analysis method and evaluation method (2)>

### (1) Evaluation on stability of hydrogen peroxide

As substitutes of metal residues mixed after cleaning semiconductor substrates, each of standard solutions of metal ions and cobalt ions (ICP standard solution Co1000 (1000 ppm by mass), manufactured by FUJIFILM Wako Pure Chemical Corporation) was added to cleaning compositions for semiconductor substrates in Examples and Comparative Examples, to satisfy the amount shown in Table 6. The amount of hydrogen peroxide immediately after the addition and the amount of hydrogen peroxide after warming at 50°C for 6 hours were measured according to the method described in JIS K1463:2007 with use of potassium permanganate to obtain the residual ratio of hydrogen peroxide (unit: %). The stability of hydrogen peroxide increases with increase in the residual ratio of hydrogen peroxide.

Incidentally, the respective metal ions described above are ions of the following metals: tantalum (group V element), ruthenium (group VIII element), manganese (group VII element), magnesium, titanium (group IV elements), aluminum, tungsten (group VI elements), zirconium (group IV element), and hafnium (group IV element).

### Example 42

A cleaning composition for semiconductor substrates was obtained by compounding 15 parts by mass of hydrogen peroxide (48.39 parts by mass of 31% hydrogen peroxide aqueous solution was compounded to satisfy the amount of active ingredient described above), 0.2 parts by mass of potassium hydroxide, 0.5 parts by mass of tetramethylammonium hydroxide, 0.002 parts by mass of diethylenetriaminepenta(methylenephosphonic acid), and 0.05 parts by mass of diethylenetriaminepentaacetic acid as a hydrogen peroxide stabilizing agent (B), and diluting the mixture with ultrapure water to make 100 parts by mass of the total. The evaluation shown in Table 6 was performed. In each of tables below, the amount of each component compounded is shown in terms of "mass%".

### Examples 43 to 45

Cleaning compositions for semiconductor substrates were obtained in the same manner as in Example 42, except that 0.05 parts by mass of diethylenetriaminepentaacetic acid in Example 42 was replaced with each of the compounds and the amount compounded shown in Table 6. The evaluation results are shown in Table 6.

### Examples 46 and 47

Cleaning compositions for semiconductor substrates were obtained in the same manner as in Example 42, except that 0.05 parts by mass of diethylenetriaminepentaacetic acid in Example 42 was replaced with each of the compounds and the amount compounded shown in Table 7. The evaluation results are shown in Table 7.

### Comparative Example 41

A cleaning composition for semiconductor substrates was obtained in the same manner as in Example 42, except that 0.05 parts by mass of diethylenetriaminepentaacetic acid in Example 42 was not used and the amount of ultrapure water was adjusted to make 100 parts by mass of the total. The evaluation results are shown in Table 7.

### Reference Example 3

As a reference example, evaluation on the stability of hydrogen peroxide was performed using the cleaning composition for semiconductor substrates in Comparative Example 41, with addition of cobalt ions alone. The results are shown in Table 7.

**Table 6**

| | Cleaning composition for semiconductor devices | | Evaluation | | | |
|---|---|---|---|---|---|---|
| | Compound of hydrogen peroxide stabilizing agent (B) | | Stability of hydrogen peroxide | | | |
| | | Amount compoundec (mass%) | Metal | Metal (ppb by mass) | Cobalt (ppb by mass) | Residual ratio of hydrogen peroxide (%) |
| Example 42 | DTPA (Diethylenetriaminepentaacetic acid) | 0.05 | Tantalum | 1000 | 400 | 99 |
| | | 0.05 | Ruthenium | 1000 | 400 | 98 |
| | | 0.05 | Manganese | 1000 | 400 | 95 |
| | | 0.05 | Magnesium | 1000 | 400 | 98 |
| | | 0.05 | Titanium | 1000 | 400 | 97 |
| | | 0.05 | Aluminum | 1000 | 400 | 98 |
| | | 0.05 | Tungsten | 1000 | 400 | 97 |
| | | 0.05 | Zirconium | 1000 | 400 | 97 |
| | | 0.05 | Hafnium | 1000 | 400 | 97 |
| Example 43 | HIDA (Hydroxyethyliminodiacetic acid) | 0.15 | Tantalum | 1000 | 400 | 97 |
| | | 0.15 | Ruthenium | 1000 | 400 | 97 |
| | | 0.15 | Manganese | 1000 | 400 | 70 |
| | | 0.15 | Magnesium | 1000 | 400 | 97 |
| | | 0.15 | Titanium | 1000 | 400 | 97 |
| | | 0.15 | Aluminum | 1000 | 400 | 95 |
| | | 0.15 | Tungsten | 1000 | 400 | 100 |
| | | 0.15 | Zirconium | 1000 | 400 | 98 |
| | | 0.15 | Hafnium | 1000 | 400 | 98 |
| Example 44 | TTHA (Triethylenetetraminehexaacetic acid) | 0.03 | Tantalum | 1000 | 400 | 100 |
| | | 0.03 | Ruthenium | 1000 | 400 | 100 |
| | | 0.03 | Manganese | 1000 | 400 | 97 |
| | | 0.03 | Magnesium | 1000 | 400 | 100 |
| | | 0.03 | Titanium | 1000 | 400 | 99 |
| | | 0.03 | Aluminum | 1000 | 400 | 100 |
| | | 0.03 | Tungsten | 1000 | 400 | 100 |
| | | 0.03 | Zirconium | 1000 | 400 | 100 |
| | | 0.03 | Hafnium | 1000 | 400 | 100 |
| Example 45 | 8-Quinolinol | 0.005 | Tantalum | 1000 | 400 | 100 |
| | | 0.005 | Ruthenium | 1000 | 400 | 100 |
| | | 0.005 | Manganese | 1000 | 400 | 85 |
| | | 0.005 | Magnesium | 1000 | 400 | 100 |
| | | 0.005 | Titanium | 1000 | 400 | 100 |
| | | 0.005 | Aluminum | 1000 | 400 | 100 |
| | | 0.005 | Tungsten | 1000 | 400 | 100 |
| | | 0.005 | Zirconium | 1000 | 400 | 100 |
| | | 0.005 | Hafnium | 1000 | 400 | 100 |

| | | | | | | |
|---|---|---|---|---|---|---|
| *) In the cleaning compositions for semiconductor substrates in Table 6 (Examples 42 to 47, Comparative Example 41, and Reference Example 3), 15 mass% of hydrogen peroxide, 0.2 mass% of potassium hydroxide, 0.5 mass% of tetramethylammonium hydroxide, and 0.002 mass% of diethylenetriaminepenta(methylenephosphonic acid) are contained. | | | | | | |

**Table 7**

| | Cleaning composition for semiconductor devices | | Evaluation | | | |
|---|---|---|---|---|---|---|
| | Compound of hydrogen peroxide stabilizing agent (B) | | Stability of hydrogen peroxide | | | |
| | | Amount compounded (mass%) | Metal | Metal (ppb by mass) | Cobalt (ppb by mass) | Residual ratio of hydrogen peroxide (%) |
| Example 46 | HEDTA (Hydroxyethylethylenediaminetriacetic acid) | 0.15 | Tantalum | 1000 | 400 | 100 |
| | | 0.15 | Ruthenium | 1000 | 400 | 100 |
| | | 0.15 | Manganese | 1000 | 400 | 99 |
| | | 0.15 | Magnesium | 1000 | 400 | 100 |
| | | 0.15 | Titanium | 1000 | 400 | 100 |
| | | 0.15 | Aluminum | 1000 | 400 | 100 |
| | | 0.15 | Tungsten | 1000 | 400 | 100 |
| | | 0.15 | Zirconium | 1000 | 400 | 100 |
| | | 0.15 | Hafnium | 1000 | 400 | 100 |
| Example 47 | CyDTA (trans-1,2-cyclohexanediaminetetraacetic acid monohydrate) | 0.005 | Tantalum | 1000 | 400 | 100 |
| | | 0.005 | Ruthenium | 1000 | 400 | 100 |
| | | 0.005 | Manganese | 1000 | 400 | 100 |
| | | 0.005 | Magnesium | 1000 | 400 | 100 |
| | | 0.005 | Titanium | 1000 | 400 | 100 |
| | | 0.005 | Aluminum | 1000 | 400 | 100 |
| | | 0.005 | Tungsten | 1000 | 400 | 100 |
| | | 0.005 | Zirconium | 1000 | 400 | 100 |
| | | 0.005 | Hafnium | 1000 | 400 | 100 |
| Comparative Example 41 | None | | Tantalum | 1000 | 400 | 75 |
| | | | Ruthenium | 1000 | 400 | 68 |
| | | | Manganese | 1000 | 400 | 21 |
| | | | Magnesium | 1000 | 400 | 0 |
| | | | Titanium | 1000 | 400 | 66 |
| | | | Aluminum | 1000 | 400 | 26 |
| | | | Tungsten | 1000 | 400 | 74 |
| | | | Zirconium | 1000 | 400 | 58 |
| | | | Hafnium | 1000 | 400 | 49 |
| Reference Example 3 | None | | None | | 400 | 80 |

| | | | | | | |
|---|---|---|---|---|---|---|
| *) In the cleaning compositions for semiconductor substrates in Table 7 (Examples 42 to 47, Comparative Example 41, and Reference Example 3), 15 mass% of hydrogen peroxide, 0.2 mass% of potassium hydroxide, 0.5 mass% of tetramethylammonium hydroxide, and 0.002 mass% of diethylenetriaminepenta(methylenephosphonic acid) are contained. | | | | | | |

As shown in Tables 6 and 7, it is evident that the cleaning compositions for semiconductor substrates in Examples have high stability of hydrogen peroxide even in the presence of two types of ions of a specific metal (group IV element, group V element, group VI element, group VII element, group VIII element, magnesium and aluminum) and cobalt.

## Claims

1. A cleaning composition for semiconductor substrates, comprising hydrogen peroxide (A), a hydrogen peroxide stabilizing agent (B), an alkaline compound (C), and water, wherein
the hydrogen peroxide stabilizing agent (B) is at least one selected from the group consisting of oxalic acid, diethylenetriaminepentaacetic acid,
hydroxyethyliminodiacetic acid, potassium oxalate, 5-phenyl-1H-tetrazole,
triethylenetetraminehexaacetic acid, trans-1,2-cyclohexanediaminetetraacetic acid, 8-quinolinol, L(+)-isoleucine, DL-valine, L(-)-proline,
hydroxyethylethylenediaminetriacetic acid, N,N-di(2-hydroxyethyl)glycine, glycine, L-tryptophan, 2,6-pyridinedicarboxylic acid, benzothiazole, and DL-alanine; and
the alkaline compound (C) is at least one selected from the group consisting of a quaternary ammonium hydroxide (C1) and potassium hydroxide (C2).

2. The cleaning composition for semiconductor substrates according to claim 1, wherein the content of the hydrogen peroxide stabilizing agent (B) in the cleaning composition for semiconductor substrates is 0.0001 to 5 mass%.

3. The cleaning composition for semiconductor substrates according to claim 1 or 2, wherein the content of hydrogen peroxide (A) in the cleaning composition for semiconductor substrates is 10 to 30 mass%.

4. The cleaning composition for semiconductor substrates according to any one of claims 1 to 3, having a pH of 7 to 12.

5. The cleaning composition for semiconductor substrates according to any one of claims 1 to 4, further comprising an aminopolymethylene phosphonic acid (D).

6. The cleaning composition for semiconductor substrates according to claim 5, wherein the content of the aminopolymethylene phosphonic acid (D) in the cleaning composition for semiconductor substrates is 0.00005 to 0.005 mass%.

7. The cleaning composition for semiconductor substrates according to any one of claims 1 to 6, wherein the content of the quaternary ammonium hydroxide (C1) in the cleaning composition for semiconductor substrates is 0.005 to 10 mass%.

8. The cleaning composition for semiconductor substrates according to any one of claims 1 to 7, wherein the content of potassium hydroxide (C2) in the cleaning composition for semiconductor substrates is 0.005 to 5 mass%.

9. The cleaning composition for semiconductor substrates according to any one of claims 1 to 8, wherein the quaternary ammonium hydroxide (C1) is at least one selected from the group consisting of tetramethylammonium hydroxide, tetraethylammonium hydroxide, tetrapropylammonium hydroxide, tetrabutylammonium hydroxide, and benzyltrimethylammonium hydroxide.

10. The cleaning composition for semiconductor substrates according to any one of claims 5 to 9, wherein the aminopolymethylene phosphonic acid (D) is at least one selected from the group consisting of aminotri(methylenephosphonic acid), ethylenediaminetetra(methylenephosphonic acid), diethylenetriaminepenta(methylenephosphonic acid), and 1,2-propylenediaminetetra(methylenephosphonic acid).

11. The cleaning composition for semiconductor substrates according to any one of claims 1 to 10, wherein the hydrogen peroxide stabilizing agent (B) is at least one selected from the group consisting of oxalic acid, diethylenetriaminepentaacetic acid, hydroxyethyliminodiacetic acid, potassium oxalate, triethylenetetraminehexaacetic acid, trans-1,2-cyclohexanediaminetetraacetic acid, 8-quinolinol, hydroxyethylethylenediaminetriacetic acid, 5-phenyl-1H-tetrazole, N,N-di(2-hydroxyethyl)glycine, and benzothiazole.

12. The cleaning composition for semiconductor substrates according to any one of claims 1 to 11, substantially free of ammonia and ammonium ion (NH₄⁺).

13. The cleaning composition for semiconductor substrates according to any one of claims 1 to 12, for use in cleaning semiconductor substrates having a hard mask containing at least one selected from the group consisting of titanium and titanium nitride.

14. The cleaning composition for semiconductor substrates according to any one of claims 1 to 13, for use in cleaning semiconductor substrates containing cobalt and copper.

15. The cleaning composition for semiconductor substrates according to any one of claims 1 to 14, wherein, after addition of 400 ppb by mass of cobalt ions and 1000 ppb by mass of copper ions based on the total amount of the cleaning composition for semiconductor substrates and treatment at 50°C for 6 hours, the residual ratio of hydrogen peroxide (A) is 50% or more based on the content of hydrogen peroxide before the treatment.

16. The cleaning composition for semiconductor substrates according to any one of claims 1 to 13, for use in cleaning semiconductor substrates containing: at least one metal selected from the group consisting of group IV elements, group V elements, group VI elements, group VII elements, group VIII elements, magnesium and aluminum; and cobalt.

17. The cleaning composition for semiconductor substrates according to claim 16, wherein the at least one metal selected from the group consisting of group IV elements, group V elements, group VI elements, group VII elements, group VIII elements, magnesium and aluminum is at least one metal selected from the group consisting of titanium, zirconium, hafnium, tantalum, tungsten, manganese, ruthenium, magnesium and aluminum.

18. A cleaning method for cleaning a semiconductor substrate by using the cleaning composition for semiconductor substrates according to any one of claims 1 to 15 under coexistence of cobalt ions and copper ions.

19. A cleaning method for cleaning a semiconductor substrate containing cobalt and copper by using the cleaning composition for semiconductor substrates according to any one of claims 1 to 15.

20. A cleaning method for cleaning a semiconductor substrate by using the cleaning composition for semiconductor substrates according to any one of claims 1 to 13 and claims 16 and 17 under coexistence of ions of at least one metal selected from the group consisting of group IV elements, group V elements, group VI elements, group VII elements, group VIII elements, magnesium and aluminum, and of cobalt ions.

21. A cleaning method for cleaning a semiconductor substrate containing: at least one metal selected from the group consisting of group IV elements, group V elements, group VI elements, group VII elements, group VIII elements, magnesium and aluminum; and cobalt, by using the cleaning composition for semiconductor substrates according to any one of claims 1 to 13 and claims 16 and 17.

22. The cleaning method according to any one of claims 18 to 21, for cleaning a semiconductor substrate having a hard mask containing at least one selected from the group consisting of titanium and titanium nitride.

23. A cleaning method for removing at least one selected from the group consisting of dry etching residues and a hard mask in a semiconductor substrate by using the cleaning composition for semiconductor substrates according to any one of claims 1 to 17.

24. A method for stabilizing hydrogen peroxide, comprising using at least one hydrogen peroxide stabilizing agent (B) selected from the group consisting of oxalic acid, diethylenetriaminepentaacetic acid, hydroxyethyliminodiacetic acid, potassium oxalate, 5-phenyl-1H-tetrazole, triethylenetetraminehexaacetic acid, trans-1,2-cyclohexanediaminetetraacetic acid, 8-quinolinol, L(+)-isoleucine, DL-valine, L(-)-proline, hydroxyethylethylenediaminetriacetic acid, N,N-di(2-hydroxyethyl)glycine, glycine, L-tryptophan, 2,6-pyridinedicarboxylic acid, benzothiazole, and DL-alanine, in a liquid containing hydrogen peroxide (A), cobalt ions, copper ions and water, to thereby stabilize hydrogen peroxide (A).

25. The method for stabilizing hydrogen peroxide according to claim 24, wherein the liquid containing hydrogen peroxide (A), cobalt ions, copper ions and water has a pH of 7 to 12.

26. A method for stabilizing hydrogen peroxide, comprising using at least one hydrogen peroxide stabilizing agent (B) selected from the group consisting of oxalic acid, diethylenetriaminepentaacetic acid, hydroxyethyliminodiacetic acid, potassium oxalate, 5-phenyl-1H-tetrazole, triethylenetetraminehexaacetic acid, trans-1,2-cyclohexanediaminetetraacetic acid, 8-quinolinol, L(+)-isoleucine, DL-valine, L(-)-proline, hydroxyethylethylenediaminetriacetic acid, N,N-di(2-hydroxyethyl)glycine, glycine, L-tryptophan, 2,6-pyridinedicarboxylic acid, benzothiazole, and DL-alanine, in a liquid containing hydrogen peroxide (A), ions of at least one metal selected from the group consisting of group IV elements, group V elements, group VI elements, group VII elements, group VIII elements, magnesium and aluminum, cobalt ions and water, to thereby stabilize hydrogen peroxide (A).

27. The method for stabilizing hydrogen peroxide according to claim 26, wherein the liquid containing hydrogen peroxide (A), ions of at least one metal selected from the group consisting of group IV elements, group V elements, group VI elements, group VII elements, group VIII elements, magnesium and aluminum, cobalt ions and water, has a pH of 7 to 12.

28. A method for producing a semiconductor substrate, comprising a step of removing at least one selected from the group consisting of dry etching residues and a hard mask in the semiconductor substrates, by using the cleaning composition for semiconductor substrates according to any one of claims 1 to 17.
